# EUROPEAN PATENT SPECIFICATION

(11) **EP 3 136 598 B1**
(45) Date of publication and mention of the grant of the patent: **06.06.2018**
(21) Application number: 15782817.9
(22) Date of filing: 06.03.2015
(51) Int. Cl.: G06F 13/28, G06F 13/40, H03K 7/08

(54) **METHOD FOR ON/OFF CONTROL OF SWITCH, AND SWITCH CIRCUIT**
VERFAHREN ZUR EIN-/AUS-STEUERUNG VON SCHALTERS UND SCHALTKREIS
PROCÉDÉ DE COMMANDE MARCHE/ARRÊT D'UN COMMUTATEUR ET CIRCUIT DE COMMUTATION

(30) Priority: 25.04.2014 JP 2014091944
(43) Date of publication of application: 01.03.2017
(73) Proprietor: AutoNetworks Technologies, Ltd., Yokkaichi-shi, Mie 510-8503 (JP); Sumitomo Wiring Systems, Ltd., Yokkaichi-shi, Mie 510-8503 (JP); Sumitomo Electric Industries, Ltd., Osaka-shi, Osaka 541-0041 (JP)
(72) Inventor: KANAZAWA, Akira, Yokkaichi-shi Mie 510-8503 (JP); FURUTO, Ken, Yokkaichi-shi Mie 510-8503 (JP); MESAKI, Genta, Yokkaichi-shi Mie 510-8503 (JP); MAEDA, Kazuki, Yokkaichi-shi Mie 510-8503 (JP)
(74) Representative: Horn Kleimann Waitzhofer Patentanwälte PartG mbB
(86) International application number: PCT/JP2015/056620
(87) International publication number: WO 2015/163021

(56) References cited:
- JP-A- 2011 211 271
- US-A- 5 793 808
- 'RL78/G13 Group Multiple PWM generation using DMA' APPLICATION NOTE, R01AN1023EJ0100, REV. 1.00, [Online] 31 March 2012, pages 2 - 5, XP055232646 Retrieved from the Internet: <URL:http:// documentation.renesas.com/doc/products/mpum cu/ apn/r178/r01an1023ej0100_r178g13.pdf> [retrieved on 2015-04-23]

## Description

### Technical Field

The present invention relates to a switch on/off control method for being performed in a switch circuit that is provided with: a DMA controller for periodically DMA-transferring a plurality of pieces of transfer data in a memory; and a switch that is controlled to be turned on/off based on the transfer data from the DMA controller, and relates to the switch circuit.

### Background Art

In recent years, variety of switch circuits, called IPDs (Intelligent Power Devices), have been commercialized. IPDs have, for example, a function to protect a built-in switch from an overcurrent, a function to sense an electric current flowing through the switch, and the like. By controlling such an IPD to be turned on/off with a PWM signal to switch a power-supply voltage, electric power control is performed easily and safely on a load that is connected to an electric power supply via the IPD.

A PWM signal for use in PWM control may be generated, without intervention of software, based on, for example, a comparison result between an error voltage between a feedback control amount (output value) and a target value, and a voltage of a saw-tooth wave or a triangle wave. On the other hand, a PWM signal may be generated with software control based on, for example, a timer interrupt.

If a PWM signal is generated with software control, a processing load of a CPU will increase due to rising of the PWM signal changing from OFF to ON, or falling of the PWM signal changing from ON to OFF. Also, when the CPU is e.g. in an interrupt-disabled state, timer interrupt processing may delay, and an error may occur in the duty ratio of the PWM signal.

In order to solve the problems, Non-patent Document 1 discloses a method for outputting a PWM signal in synchronization with DMA transfer from an I/O port, using a configuration in which the DMA transfer is periodically performed to the I/O port from a PWM reference table in which a plurality of pieces of 1/0 data are written that correspond to on/off of the PWM signal. According to the method disclosed in Non-patent Document 1, since a CPU only needs to update the PWM reference table and periodically set and start the DMA transfer, a processing load of the CPU is reduced.

Meanwhile, some IPDs such as "SPOC (registered trademark)" of Infineon AG include a switch that is controlled to be turned on/off based on a command given via a serial communication interface. SPOC is provided with the communication interface that conforms to the communication standard called "SPI (registered trademark)". Infineon AG introduces, in Non-patent Document 2, an example in which series of commands for realizing PWM control using SPOC are periodically given to the SPOC. Specifically, a method called "raster method" is used to give commands for one period that are necessary for PWM control to the SPOC one by one at predetermined time intervals. In this case, the DMA transfer technique disclosed in Non-patent Document 1 is applied.

### Citation List

### Non-patent Documents

Non-patent Document 1: "Multiple PWM generation with RL78/G13 DMA", Application Note, R01AN1023JJ0100, Rev. 1.00, [online], Feb. 29, 2012, Renesas Electronics Corporation, P3, [searched on Feb. 17, 2014], Internet <URL:http://documentation.renesas.com/doc/products/mpumcu/apn/rl78 /r01an1023jj0100#rl78g13.pdf>
Non-patent Document 2: "How to drive loads with PWM over the SPI bus: Introduction", [online], 2013/10/16, Infineon AG Technologies, [searched on Feb. 17, 2014], Internet <URL:http://www.youtube.com /watch?v=obFP7GDJDus>

### Summary of Invention

### Technical Problem

However, according to the technique disclosed in Non-patent Document 2, since the CPU needs to write the commands for one period for use in PWM control to the memory, and then to set and start DMA transfer, a processing load of generating the commands for one period and writing the generated commands to the memory is still not light.

The present invention was made in view of such circumstances, and it is an object thereof to realize a switch on/off control method and a switch circuit that can reduce a processing load when controlling on/off of a switch whose various operations are controlled based on control data.

### Solution to Problem

According to the present invention, a switch on/off control method for being performed in a switch circuit that is provided with: a DMA controller for DMA-transferring all of a plurality of pieces of transfer data written in a predetermined region of a memory in a predetermined period; and a switch that is controlled to be turned on/off based on the transfer data from the DMA controller is such that the transfer data is ON data for use in controlling the switch to be turned on, OFF data for use in controlling the switch to be turned off, or third data for use other than in controlling the switch to be turned on/off, the third data is written in advance in the entire predetermined region, transfer source addresses from which the transfer data is DMA-transferred to the switch at a phase at which the switch is to be controlled to be turned on and a phase at which the switch is to be controlled to be turned off are respectively calculated, the phases being included in the predetermined period, and the ON data and the OFF data are respectively written over the third data that was written at the calculated transfer source addresses.

The switch on/off control method according to the present invention may be such that the third data is written over a content of the transfer source address at which the ON data (or OFF data) was written, the transfer source address from which the transfer data is DMA-transferred to the switch is updated at the phase at which the switch is to be controlled to be turned on (or phase at which the switch is to be controlled to be turned off), and the ON data (or OFF data) is written over the third data that was written at the updated transfer source address.

The switch on/off control method according to the present invention may be such that a storage section is prepared, the transfer source address at which the ON data (or OFF data) was written is stored in the storage section, the transfer source address stored in the storage section, and the updated transfer source address are compared with each other, and if a result of the comparison shows that the transfer source addresses match each other, overwriting of the third data and overwriting of the ON data (or OFF data) are disabled.

The switch on/off control method according to the present invention may be such that the ON data (or OFF data) is written over the third data that was written at a calculated or updated transfer source address, and an address distanced from the calculated or updated transfer source address.

The switch on/off control method according to the present invention may be such that a second storage section is prepared, the switch circuit is provided with a plurality of the switches, the plurality of switches are configured to be individually controlled to be turned on and off by one of the pieces of transfer data from the DMA controller, a range of phases at which none of the switches is controlled to be turned on/off is set in advance in the predetermined period, a range of transfer source addresses from which the transfer data is DMA-transferred to the switch within the set range of phases is stored in the second storage section, another piece of third data is written over the third data that was written at a suitable address within the range of transfer source addresses that was stored in the second storage section.

The switch on/off control method according to the present invention may be such that transfer source addresses from which the transfer data is DMA-transferred to the switch at the phase at which the switch is to be controlled to be turned on, and the phase at which the switch is to be controlled to be turned off are respectively calculated from odd-numbered (or even-numbered) addresses in the predetermined region, and another piece of third data is written over the third data that was written at a suitable address of even-numbered (or odd-numbered) addresses in the predetermined region.

The switch on/off control method according to the present invention may be such that a boundary between pieces of transfer data that are to be DMA-transferred sequentially in the predetermined region is set in advance, and while a piece of transfer data located on a front side (or rear side) of the boundary is DMA-transferred, another piece of transfer data is written over a suitable piece of transfer data on the rear side (or front side).

According to the present invention, a switch circuit includes: a DMA controller for DMA transferring all of a plurality of pieces of transfer data written in a predetermined region of a memory in a predetermined period, and a switch that is controlled to be turned on/off based on the transfer data from the DMA controller, wherein the transfer data is ON data for use in controlling the switch to be turned on, OFF data for use in controlling the switch to be turned off, or third data for use other than in controlling the switch to be turned on/off, and the switch circuit further includes: writing means for writing the third data in the entire predetermined region; calculating means for calculating transfer source addresses from which the transfer data is DMA-transferred to the switch at a phase at which the switch is to be controlled to be turned on and a phase at which the switch is to be controlled to be turned off, the phases being included in the predetermined period; and overwriting means for respectively writing the ON data and OFF data over the third data that was written at the transfer source addresses calculated by the calculating means.

The switch circuit according to the present invention further includes: second overwriting means for writing the third data over a content of the transfer source address at which the ON data (or OFF data) was written; and updating means for updating the transfer source address from which the transfer data is DMA-transferred to the switch at the phase at which the switch is to be controlled to be turned on (or a phase at which the switch is to be controlled to be turned off), wherein the overwriting means is configured to write the ON data (or OFF data) over the third data that was written at the transfer source address updated by the updating means.

The switch circuit according to the present invention further includes: storing means for storing the transfer source address at which the ON data (or OFF data) was written; comparing means for comparing the transfer source address stored by the storing means and the transfer source address updated by the updating means; and disabling means for disabling overwriting of the third data and overwriting of the ON data (or OFF data) if a result of the comparison by the comparing means shows that the transfer source addresses match each other.

The switch circuit according to the present invention may be such that the overwriting means is configured to write the ON data (of OFF data) over third data that was written at the transfer source address that was calculated by the calculating means or updated by the updating means, and an address distanced from the calculated or updated transfer source address.

The switch circuit according to the present invention may be such that the switch circuit is provided with a plurality of the switches, the plurality of switches are configured to be individually controlled to be turned on and off by one of the pieces of transfer data from the DMA controller, and a range of phases at which none of the switches is controlled to be turned on/off is set in advance in the predetermined period, the switch circuit further includes: second storing means for storing a range of transfer source addresses from which the transfer data is DMA-transferred to the switch within the set range of phases; and third overwriting means for writing another piece of third data over the third data that was written at a suitable address within the range of transfer source addresses that was stored by the second storing means.

The switch circuit according to the present invention further includes: second calculating means for calculating transfer source addresses from which the transfer data is DMA-transferred to the switch at the phase at which the switch is to be controlled to be turned on and the phase at which the switch is to be controlled to be turned off, from odd-numbered (or even-numbered) addresses in the predetermined region; and fourth overwriting means for writing another piece of third data over the third data that was written at a suitable address of even-numbered (or odd-numbered) addresses in the predetermined region.

The switch circuit according to the present invention may be such that a boundary between pieces of transfer data that are to be DMA-transferred sequentially in the predetermined region is set in advance, and the switch circuit further comprises fifth overwriting means for writing, while a piece of transfer data located on a front side (or rear side) of the boundary is DMA-transferred, another piece of transfer data over a suitable piece of transfer data on the rear side (or front side).

According to the present invention, all of a plurality of pieces of transfer data in a predetermined region of the memory are DMA-transferred in a predetermined period, and the pieces of DMA-transferred transfer data are given to the switch to control the switch to be turned on/off periodically. The transfer data is ON data/OFF data for controlling the switch to be turned on/off, or third data that is irrelevant to the on/off control of the switch. Among the transfer data, the third data was written in advance in the entire predetermined region. For example, when phases at which the switch is to be controlled to be turned on and off in the predetermined period are obtained, or when a target duty ratio is given so that phases at which the switch is controlled to be turned on and off are calculated, transfer source addresses from which the transfer data is DMA-transferred to the switch at the obtained or calculated phases are calculated, and ON data and OFF data are written over the third data that was written in advance at the calculated transfer source addresses.

In short, fixed control data irrelevant to the on/off control of the switch was uniformly written in the entire predetermined region of the memory, ON data and OFF data are written over contents of the transfer source addresses of the memory that correspond to the phases at which the switch is to be controlled to be turned on and off, and then all the pieces of transfer data in the predetermined region of the memory are sequentially DMA-transferred. Therefore, the switch is controlled to be turned on/off at the phases that correspond to the transfer source addresses at which the ON data and the OFF data were written.

According to the present invention, prior to updating the phases at which the switch is controlled to be turned on/off, the third data is written over the content of the non-updated transfer source address at which ON data and/or OFF data was written. Then, the transfer source address from which the transfer data is DMA-transferred to the switch is updated at a new phase at which the switch is to be controlled to be turned on and/or off. Then, when the transfer source address for ON control of the switch is updated, ON data is written over the content of the updated transfer source address, and when the transfer source address for OFF control of the switch is updated, OFF data is written over the content of the updated transfer source address.

In short, when the transfer source address at which ON data and/or OFF data is to be written is updated, third data is written over the content of the non-updated transfer source address, the transfer source address is updated in response to the overwriting, and ON data and/or OFF data is written over the content of the updated transfer source address, making it easy to update the phase at which the switch is to be controlled to be turned on and/or off.

According to the present invention, the non-updated transfer source address at which ON data and/or OFF data was written is stored in the storage section, and the stored transfer source address and the updated transfer source address are compared with each other. Writing of the third data over the ON data and/or OFF data that was written at the matching address, and writing of ON data and/or OFF data over the third data are disabled.

Accordingly, if the transfer source addresses for the ON data and/or OFF data does not change between before and after updating of the phase at which the switch is to be controlled to be turned on and/or off, unnecessary writing into the predetermined region of the memory will be omitted.

According to the present invention, if ON data is written over third data that was written at the calculated transfer source address, ON data will also be written over third data that was written at an address distanced to the front/rear from the calculated transfer source address. Furthermore, if OFF data is written over third data that was written at the calculated transfer source address, OFF data will also be written over third data that was written at an address distanced to the front/rear from the calculated transfer source address.

Accordingly, since either or both of ON data and OFF data is written two times, on/off control of the switch is reliably performed.

According to the present invention, if a range of phases at which none of the plurality of switches, which are individually controlled to be turned on/off by one piece of the transfer data, is set in advance, a range of transfer source addresses from which the transfer data is DMA-transferred to the switch within the set range of phases is stored in the second storage section. In this range of transfer source addresses, third data is always stored. In this state, when, for example, a control other than on/off control is performed on the switch, another piece of third data that corresponds to the other control is written over the third data that was written at a suitable address within the range of transfer source addresses stored in the second storage section.

Accordingly, another control is performed on the switch, without the need of searching a transfer source address at which another piece of third data is allowed to be written over, and without affecting on/off control of the switch.

According to the present invention, both addresses over whose contents ON data and OFF data are respectively to be written are calculated from odd-numbered addresses or even-numbered addresses in the predetermined region of the memory. If, in this state, for example, a control other than on/off control is performed on the switch, and ON data and OFF data are written over the contents of the odd-numbered addresses, another piece of third data that corresponds to the other control will be written over the content of a suitable address of the even-numbered addresses. Furthermore, if ON data and OFF data are written over the contents of even-numbered addresses, another piece of third data that corresponds to the control will be written over the content of a suitable address of the odd-numbered addresses.

Accordingly, another control is performed on the switch as needed, without the need of searching a transfer source address at which another piece of third data is allowed to be written over, and without affecting on/off control of the switch.

According to the present invention, if processing for updating transfer data in the predetermined region of the memory is divided temporally into, for example, two parts, namely, first and second processes, a boundary between pieces of transfer data that are to be updated in the respective divided processes is set in advance. Then, while the transfer data located on the front side of the set boundary is DMA-transferred, another piece of transfer data is written over a suitable piece of transfer data on the rear side of the set boundary and is updated. Furthermore, while the transfer data located on the rear side of the set boundary is DMA-transferred, another piece of transfer data is written over a suitable piece of transfer data on the front side of the set boundary and is updated.

Accordingly, the phase at which the switch is controlled to be turned on/off is updated without affecting the on/off control of the switch.

### Advantageous Effects of Invention

According to the present invention, pieces of fixed control data irrelevant to on/off control of a switch are uniformly written in an entire predetermined region of a memory, ON data and OFF data are written over each of two of the pieces of control data to start DMA transfer, and thereby the switch is controlled to be turned on/off.

Accordingly, it is possible to reduce a processing load when controlling on/off of a switch whose various operations are controlled based on control data.

### Brief Description of Drawings

FIG. 1 is a block diagram illustrating an example of a configuration of a switch circuit according to Embodiment 1 of the present invention.
FIG. 2 shows timing diagrams illustrating giving and receiving commands and responses in the switch circuit according to Embodiment 1 of the present invention.
FIG. 3 is a diagram illustrating correspondence between commands and on/off control of a FET of the switch circuit according to Embodiment 1 of the present invention.
FIG. 4 is a flowchart illustrating a processing procedure of a CPU that controls the FET to be turned on/off with the switch circuit according to Embodiment 1 of the present invention.
FIG. 5 is a diagram illustrating correspondence between commands and on/off control of a FET of a switch circuit according to Embodiment 2 of the present invention.
FIG. 6 is a flowchart illustrating a processing procedure of a CPU that updates on/off control of the FET with the switch circuit according to Embodiment 2 of the present invention.
FIG. 7A is a diagram illustrating correspondence between commands and on/off control of a FET of a switch circuit according to Embodiment 3 of the present invention.
FIG. 7B is a diagram illustrating correspondence between commands and on/off control of the FET of the switch circuit according to Embodiment 3 of the present invention.
FIG. 8 is a flowchart illustrating a processing procedure of a CPU that updates on/off control of the FET with the switch circuit according to Embodiment 3 of the present invention.
FIG. 9 is a diagram illustrating correspondence between commands and on/off control of a FET of a switch circuit according to Embodiment 4 of the present invention.
FIG. 10 is a diagram illustrating correspondence between commands and on/off control of a FET of a switch circuit according to Embodiment 5 of the present invention.
FIG. 11A is a diagram illustrating correspondence between commands and on/off control of a FET of a switch circuit according to Embodiment 6 of the present invention.
FIG. 11B is a diagram illustrating correspondence between commands and on/off control of the FET of the switch circuit according to Embodiment 6 of the present invention.

### Description of Embodiments

Hereinafter, the present invention will be described in detail with reference to the drawings illustrating embodiments thereof. The following will describe an example in which an intelligent power device, for which "SPOC" of Infineon AG is a typical example, specifically, a multiple channel IPD (hereinafter, referred to simply as "IPD") having an SPI communication interface, is used as a switch of a switch device according to the present invention.

### Embodiment 1

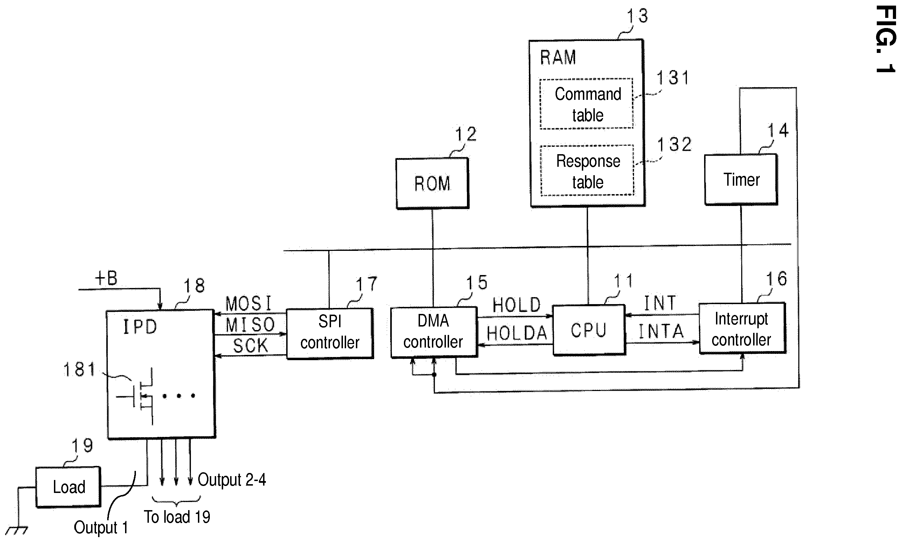

FIG. 1 is a block diagram illustrating an example of a configuration of a switch circuit according to Embodiment 1 of the present invention. The switch circuit includes a microcomputer having a CPU 11. The CPU 11 is connected, via a bus, to a ROM 12 for storing information such as a program, a RAM (that corresponds to a memory, a storage section, and a second storage section) 13 for temporarily storing information that has occurred, a timer 14 for generating a fixed-periodic signal, a DMA controller 15 for controlling DMA transfer in accordance with a DMA request, an interrupt controller 16 for processing an interrupt request, and an SPI controller 17 for performing communication conforming to the SPI.

The switch circuit is also provided with an IPD (that corresponds to a switch) 18 including four MOSFETs (hereinafter, referred to simply as "FETs") 181, and the SPI controller 17 and the IPD 18 are connected to each other via a master output/slave input (MOSI: Master Out Slave In) signal line and a master input/slave output (MISO: Master In Slave Out) signal line of SPI communication, and a clock (SCK: Serial Clock) signal line. In Embodiment 1, the SPI controller 17 is set as a master, and an SPI interface that is built in the IPD 18 and is not shown is set as a slave.

The RAM 13 includes a command table (that corresponds to a predetermined region) 131 in which a plurality of commands (that correspond to transfer data) that are to be transferred to the SPI controller 17 with DMA transfer by the DMA controller 15 are written, and a response table 132 in which responses that are to be transferred from the SPI controller 17 with DMA transfer are written. The size of the command table 131 defines the accuracy in duty ratio when the above-described FETs 181 are controlled to be turned on/off (details will be described later).

The timer 14 generates, at a fixed period, DMA requests, which serve as triggers for the DMA controller 15 to perform DMA transfer with respect to the command table 131 and the response table 132. The DMA requests generated by the timer 14 are respectively given to two DMA channels (that will be described later) of the DMA controller 15.

The DMA controller 15 has a plurality of DMA channels for respectively accepting the plurality of DMA requests. The DMA controller 15 gives a signal (so-called "HOLD signal") for requesting the CPU 11 to hold the bus when having accepted a DMA request, and executes DMA transfer in accordance with the accepted DMA request when having received an acknowledge signal (so-called "HOLDA signal") given from the CPU 11. When series of DMA transfer that were set for the respective DMA channels are complete, the DMA controller 15 gives a DMA completion interrupt request to the interrupt controller 16.

The DMA controller 15 includes, for each DMA channel, a register indicating a DMA transfer source address, a register indicating a DMA transfer destination address, a register indicating a DMA transfer count, a register indicating a DMA transfer size, the count direction (increment/decrement/fixed) of the transfer source address, and the count direction (increment/decrement/fixed) of the transfer destination address, and a register indicating whether DMA transfer is enabled/disabled, for example. Each time a DMA transfer is executed, the transfer count is decremented by one.

The interrupt controller 16 is configured to be capable of accepting a plurality of interrupt requests, and gives a signal (so-called "INT signal") for requesting the CPU 11 to interrupt when having accepted an interrupt request, and transmits, to the bus, an interrupt vector that corresponds to this interrupt request when having received an acknowledge signal (so-called "INTA signal") given from the CPU 11. When the interrupt vector transmitted to the bus is read in the CPU 11, the CPU 11 is configured to execute interrupt processing that corresponds to the corresponding interrupt request. In Embodiment 1, the highest priority is set for the DMA completion interrupt request.

The SPI controller 17 includes a transmission buffer for buffering a command to be transmitted to the MOSI signal line, and a reception buffer for buffering a response that is received from the MISO signal line. An address mapped in the memory or an address of an input-output port is assigned to each of the transmission buffer and the reception buffer, and the transmission buffer and the reception buffer are accessed from the CPU 11 or the DMA controller 15 via the bus. In Embodiment 1, the SPI controller 17 transmits a clock to the SCK signal line only while a command is transmitted, and while a response is received.

Upon receiving a command from the MOSI signal line, the IPD 18 performs processing that corresponds to the command, and transmits a response serving as a processing result to the MISO signal line. Each of the four FETs 181 of the IPD 18 is constituted by an N channel-type MOSFET, and drains of the FETs 181 are connected to a +B electric power supply, and outputs 1, 2, 3, and 4 from sources thereof are supplied to a load 19. The four FETs 181 are respectively controlled to be turned on/off with different bits included in an output command received from the MOSI signal line.

According to the above-described configuration, in DMA transfer in which a head address of the command table 131 is set as a transfer source address, the address of the transmission buffer of the SPI controller 17 is set as a transfer destination address, and the count direction of the transfer destination address is set as "fixed". The transfer size is set to 1 byte in conformity to the command length of the IPD 18. Furthermore, in DMA transfer in which the head address of the response table 132 is set as a transfer destination address, the address of the reception buffer of the SPI controller 17 is set as a transfer source address, the count direction of the transfer source address is set as "fixed", and the transfer size is set to 1 byte. The transfer source address and the transfer destination address that are respectively set at the head addresses of the command table 131 and the response table 132 are incremented by one each time the DMA transfer is performed.

Accordingly, with DMA transfer controlled by the DMA controller 15, the commands written in the command table 131 are sequentially transferred to the transmission buffer of the SPI controller 17 in periods of the DMA requests generated by the timer 14, and are transmitted to the IPD 18. Furthermore, with DMA transfer controlled by the DMA controller 15, the responses that were received by the SPI controller 17 from the IPD 18 and were buffered by the reception buffer are sequentially transferred to the response table 132 in periods of the DMA requests generated by the timer 14.

Meanwhile, a clock transmitted to the SCK signal line by the SPI controller 17 is based on a signal that is generated by a frequency divider of the SPI controller 17 that is not shown dividing the frequency of the original clock that is not shown. In order for the SPI controller 17 to transmit one command to the MOSI signal line, a time period that is at least eight-fold as long as the period of the clock is needed, but a time interval in which a command is DMA-transferred to the transmission buffer of the SPI controller 17 is configured to be sufficiently longer than that time period. In other words, the division ratio of the frequency divider is selected so that the period of the clock is sufficiently shorter than the period that is 1/8 of the period of the DMA requests generated by the timer 14.

The following will describe commands and responses that are given and received between each of the command table 131 and the response table 132, and the IPD 18.

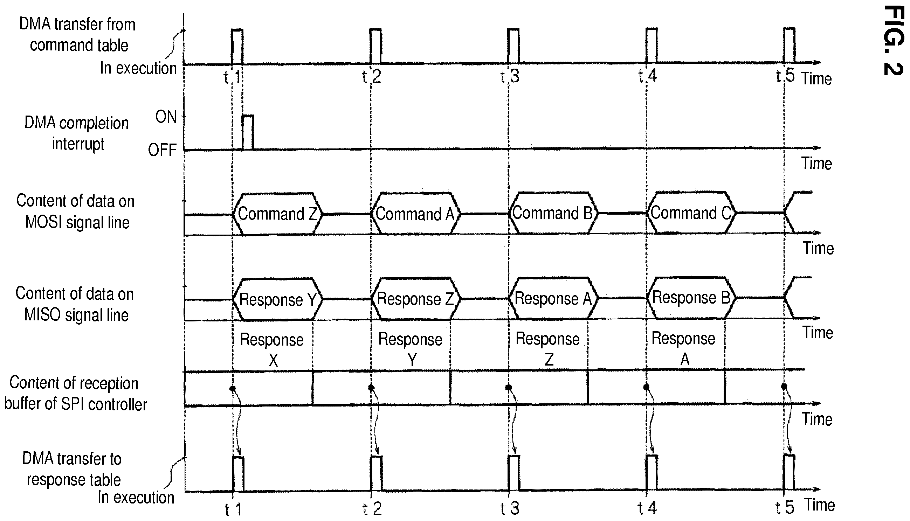

FIG. 2 shows timing diagrams illustrating giving and receiving commands and responses in the switch circuit according to Embodiment 1 of the present invention. The six timing diagrams shown in FIG. 2 share the same time axis set as a horizontal axis, and show, from above, a state showing whether or not DMA transfer from the command table 131 is in execution, a state showing whether a DMA completion interrupt that is given from the DMA controller 15 to the interrupt controller 16 is turned on or off, a content of data on the MOSI signal line, a content of data on the MISO signal line, a content of the reception buffer of the SPI controller 17, and a state showing whether or not DMA transfer to the response table 132 is in execution.

Twenty-six commands of commands A to Z in that order, for example, from the head address are written in the command table 131. The commands are DMA-transferred in periods of DMA requests generated by the timer 14. When the command Z, which was written at the end of the command table 131, is DMA-transferred to the transmission buffer of the SPI controller 17 (hereinafter, referred to simply as "transmission buffer") at time t1, the command Z is transmitted to the MOSI signal line. The response that is transmitted to the MISO signal line during the transmission of the command Z is a response Y to the command Y, which is one command before the command Z.

On the other hand, during a time period between reception of a response X, which is one response before the response Y, and completion of reception of the response Y, the response X is held in the reception buffer of the SPI controller 17 (hereinafter, referred to simply as "reception buffer"). This response X is DMA-transferred to the response table 132 at almost the same time as the DMA transfer of the command Z at time t1. Because the DMA controller 15 does not perform two DMA transfers at the same time, a slight difference occurs in time between the DMA transfer of the command Z and the DMA transfer of the response X, but here the difference in time is left out of consideration.

Meanwhile, when the DMA transfer at time t1 is complete, the DMA completion interrupt occurs from the DMA controller 15 to the interrupt controller 16, and settings for the DMA controller 15 are configured in the interrupt processing that corresponds to this DMA completion interrupt. As a result, the transfer source address of the DMA transfer from the command table 131 to the transmission buffer is set at the head address of the command table 131, that is, the address at which the command A was written. Furthermore, the transfer destination address for the DMA transfer from the reception buffer to the response table 132 is set at the head address of the response table 132.

Then, at time t2, the command A, which was written at the head address of the command table 131, is DMA-transferred to the transmission buffer and is transmitted to the MOSI signal line, and a response Z is transmitted to the MISO signal line in the meantime, or the response Y is held in the reception buffer during a time period between the reception of the response Y and completion of reception of the response Z, and this response Y is transferred to the head address of the response table 132 at almost the same time as DMA transfer of the command A at time t2.

Similarly, thereafter, at time t3, the command B, which was written at the second address of the command table 131, is DMA-transferred to the transmission buffer, and the response Z held in the reception buffer is transferred to the second address of the response table 132. Furthermore, at time t4, the command C, which was written at the third address of the command table 131, is DMA-transferred to the transmission buffer, and a response A held in the reception buffer is transferred to the third address of the response table 132. It is to be noted that, in this way, a time lag for two addresses will occur between an offset in an address at which a command was written (a difference from the head address of the table), and an offset in address at which the response corresponding to the command is to be transferred.

The following will describe a specific example in which a FET 181 is controlled to be turned on/off based on a content of the command table 131.

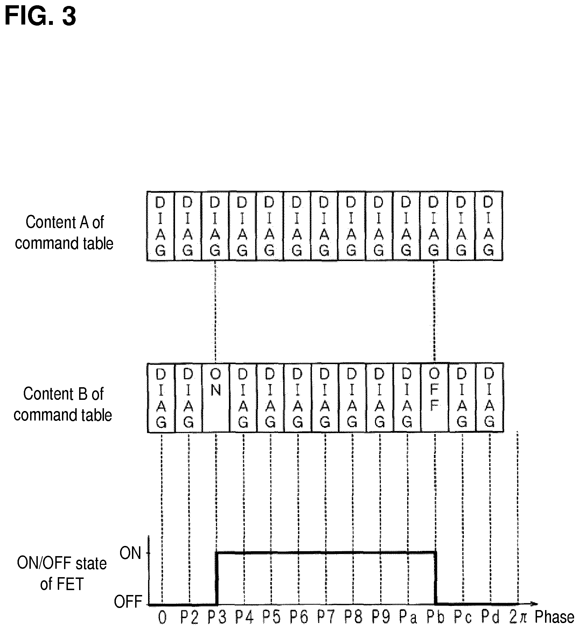

FIG. 3 is a diagram illustrating correspondence between commands and on/off control of a FET 181 of the switch circuit according to Embodiment 1 of the present invention. In FIG. 3, the horizontal axis denotes phases (in units of radian: the same applies to the following) in a period (that corresponds to a predetermined period) in which the FET 181 is controlled to be turned on/off, and the figure shows, from the upper stage thereof, content A and content B of the command table 131 that are for controlling the FET 181 to be turned on/off, and an on/off state of the FET 181. The period in which the FET 181 is controlled to be turned on/off is, for example, 10 ms.

Hereinafter, it is assumed that thirteen commands are written in the command table 131, unless otherwise noted. It is further assumed that, of the commands in the command table 131, the command at the first address controls the on/off state of the FET 181 at phase 0, and the command at the y-th (y = 2, 3, ... 10, 11, 12, 13) address controls the on/off state of the FET 181 at phase Pz (z = 2, ... a, b, c, d). Accordingly, the accuracy of the duty ratio when the FET 181 is controlled to be turned on/off is 7.7% (= 100/13). For example, if the command table 131 has a size such that one hundred commands can be written, the accuracy of the duty ratio will be 1%.

The FETs 181 to be controlled by a command are respectively designated by the low-order 4 bits of the command. If the bit that corresponds to a FET 181 is 1 (or 0), this FET 181 is controlled to be turned on (or off). Hereinafter, unless otherwise noted, commands that control a specific target FET 181 to be turned on and off are respectively denoted by "ON command (that corresponds to ON data)" and "OFF command" (that corresponds to OFF data). "DIAG command" refers to a diagnosis command (that corresponds to third data) that is irrelevant to on/off control of the FET 181.

As shown in the lower stage of FIG. 3, when the FET 181 is controlled to be turned on at phase P3, and the FET 181 is controlled to be turned off at phase Pb, it is conventionally necessary to prepare and write an OFF command at the first and the second addresses (that correspond to phases 0 and P2), and the eleventh to thirteenth addresses (that correspond to phases Pb to Pd) of the command table 131, and to prepare and write an ON command to the third to tenth addresses (that correspond to phases P3 to Pa). If the size of the command table 131 is large, there will be a problem that a processing load of the CPU 11 increases correspondingly.

In contrast, in Embodiment 1, first, as shown in the upper stage of FIG. 3, a standard DIAG command is simply copied and written in the entire region of the command table 131, that is, all consecutively numbered positions, and then, as shown in the mid stage of FIG. 3, an ON command and an OFF command are respectively written over the DIAG commands written at the third and eleventh addresses (that correspond to phases P3 and Pb) of the command table 131, thus reducing a processing load of the CPU 11. If the DMA controller 15 has an empty DMA channel, data of the DIAG command stored in, for example, the ROM 12 is written in the entire region of the command table 131 with DMA transfer, which thus drastically reduces a processing load of the CPU 11. The DIAG command may be another command such as a read-out command of a register.

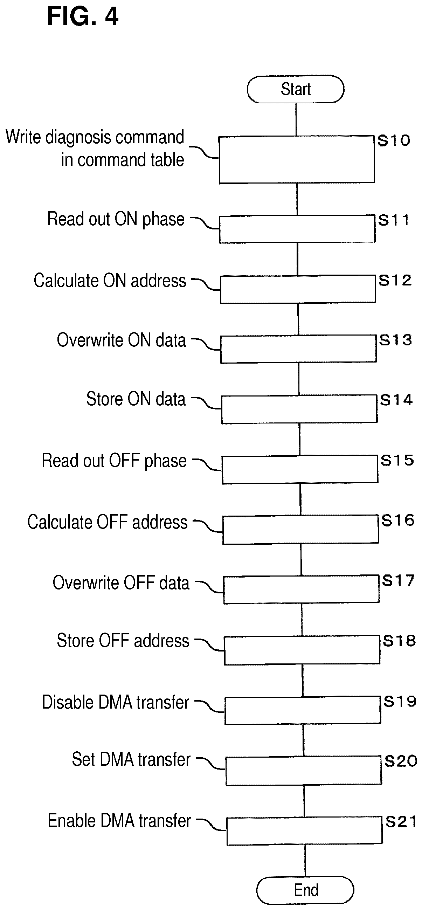

The following will describe the operation of the above-described switch circuit with reference to a flowchart illustrating the operation. The processing that will be described below is executed by the CPU 11 in accordance with a control program stored in advance in the ROM 12. FIG. 4 is a flowchart illustrating a processing procedure of the CPU 11 that controls a FET 181 to be turned on/off with the switch circuit according to Embodiment 1 of the present invention. The processing of FIG. 4 starts, for example, when the FET 181 is first controlled to be turned on/off after initialization of the switch circuit.

The ON phase and the OFF phase that are used in FIG. 4 are respectively phases at which the FET 181 is to be controlled to be turned on and off, in order to perform PWM control on electric power to be supplied to the load 19, and can be read out from the RAM 13 as needed. The ON phase and the OFF phase may be obtained externally by the CPU 11 at an appropriate time using, for example, communication means that is not shown, or may be calculated at an appropriate time by the CPU 11 based on a target duty ratio.

In the flowchart described below, an ON command, an OFF command, and a DIAG command are respectively denoted by ON data, OFF data, and a diagnosis command (the same applies to other embodiments that will be described later).

When the processing of FIG. 4 starts, the CPU 11 writes diagnosis commands in the entire region of the command table 131 (which corresponds to step S10: writing means). Then, the CPU 11 reads out an ON phase from the RAM 13 (step S11), and calculates an ON address (that corresponds to a transfer source address from which transfer data is DMA-transferred to the switch at the ON phase) at which ON data is to be written, based on the read-out ON phase (which corresponds to step S12: calculating means). Then, the CPU 11 writes the ON data over the diagnosis command written at the calculated ON address (which corresponds to step S13: overwriting means), and stores the ON address in the RAM 13 for later reference (which corresponds to step S14: storing means). Note that if, during calculation of an ON address, the ON address is stored in a register or the like of the CPU 11, the processing of step S14 will be omitted (the same applies to an OFF address).

Then, the CPU 11 reads out, from the RAM 13, an OFF phase (step S15), and calculates an OFF address (that corresponds to the transfer source address from which transfer data is DMA-transferred to the switch at the OFF phase) at which OFF data is to be written (which corresponds to step S16: calculating means), based on the read-out OFF phase. Then, the CPU 11 writes the OFF data over the diagnosis command written at the calculated OFF address (which corresponds to step S17: overwriting means), and stores the OFF address in the RAM 13 for later reference (which corresponds to step S18: storing means).

Then, the CPU 11 configures settings of disabling the controller 15 to perform DMA transfer (step S19), then configures settings of, for example, the transfer source address, and the count of transfer of DMA transfer (step S20), and lastly configures settings of enabling DMA transfer (step S21), and the processing of FIG. 4 ends.

After having configured settings of enabling DMA transfer, the DMA controller 15 accepts a fixed-periodic DMA requests from the timer 14, and the commands such as the DIAG commands, the ON command, and the OFF command that are written in the command table 131 are DMA-transferred to the SPI controller 17 one by one in a fixed period. If all the contents of the command table 131 have been DMA-transferred, it is sufficient to set that the processing shown in steps S19 to S21 of FIG. 4 are executed in the interrupt processing that corresponds to the DMA completion interrupt request. Note that, if the DMA controller 15 has a function to repeat DMA transfer, that is, if the settings of the transfer source address, the count of transfer, and the like are automatically reloaded at the completion of the DMA transfer, no specific interrupt processing is needed.

As described above, according to Embodiment 1, all the commands in the command table 131 included in the RAM 13 are DMA-transferred in a period of 10 ms for example, and the DMA-transferred commands are given to the IPD 18 to control the IPD 18 (specifically, the FETs 181 of the IPD 18: the same applies to the following) to be turned on/off in the period of 10 ms. The commands are an ON/OFF commands (ON data)(OFF data) for controlling the IPD 18 to be turned on/off, or a DIAG (diagnosis) command irrelevant to the on/off control of the IPD 18, and, among them, the DIAG commands were written in advance in the entire region of the command table 131. Then, phases at which the IPD 18 is to be controlled to be turned on and off in the period of 10 ms are read out from the RAM 13, and the transfer source addresses (an ON address and an OFF address) of the commands that are DMA-transferred to the IPD 18 at the read-out phases are calculated, and the ON command and the OFF command are written over the DIAG commands written in advance at the calculated transfer source addresses.

That is, diagnosis commands, which are fixed control data irrelevant to the on/off control of the IPD 18, are uniformly written in the entire region of the command table 131, ON data and OFF data are written over the contents of an ON address and an OFF address in the command table 131 that respectively correspond to phases at which the IPD 18 is to be controlled to be turned on and off, then all the commands in the command table 131 are sequentially DMA-transferred, and thereby the IPD 18 is controlled to be turned on/off at the phases that correspond to the ON address and the OFF address at which the ON data and the OFF data were written.

Accordingly, it is possible to reduce a processing load when controlling on/off of a switch whose various operations are controlled by control data.

### Embodiment 2

In contrast to Embodiment 1 that has an aspect in which updating of phases at which the IPD 18 is controlled to be turned on/off is out of consideration, Embodiment 2 has an aspect in which the processing of Embodiment 1 is executed and then the phases at which the IPD 18 is controlled to be turned on/off are updated.

Because a hardware configuration of a switch circuit according to Embodiment 2 is the same as that of Embodiment 1, like reference numerals are given to the corresponding components and redundant descriptions are omitted.

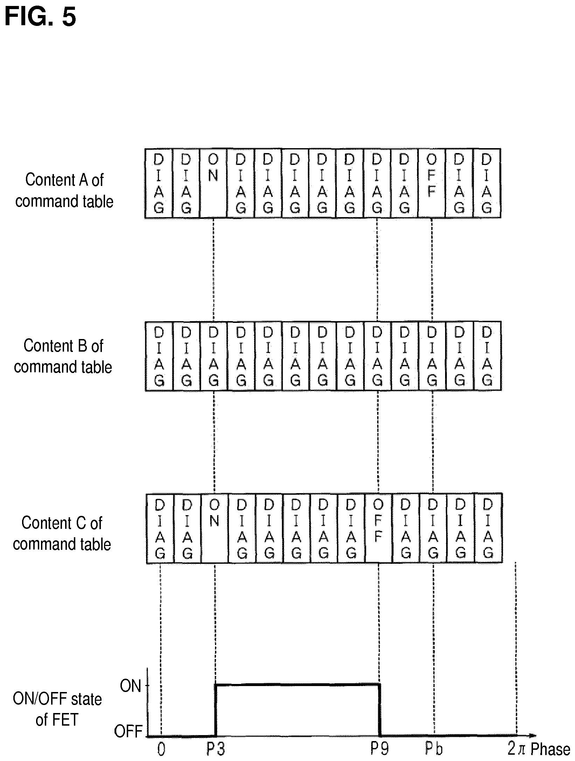

FIG. 5 is a diagram illustrating correspondence between commands and on/off control of the FET 181 of the switch circuit according to Embodiment 2 of the present invention. In FIG. 5, the horizontal axis denotes phases in a period in which the FET 181 is controlled to be turned on/off, and the figure shows, from the uppermost stage thereof, the content B, the content A, and content C of the command table 131 that are for controlling the FET 181 to be turned on/off, and an on/off state of the FET 181 in the stated order.

The following will describe a case in which the state, as shown in the lower stage of FIG. 3 above, in which the FET 181 is controlled to be turned on at phase P3 and the FET 181 is controlled to be turned off at phase Pb is updated to the state, as shown in the lowermost stage of FIG. 5, in which the FET 181 is controlled to be turned on at phase P3 and the FET 181 is controlled to be turned off at phase P9. As shown in the uppermost stage of FIG. 5, prior to the update of the control, an ON command is written at the third address of the command table 131, and an OFF command is written at the eleventh address thereof.

When updating the control, it is configured such that the entire region of the command table 131 is filled up with the DIAG commands, as shown in the second stage of FIG. 5. That is, the state moves back to the content A of the command table 131 shown in the upper stage of FIG. 3. Accordingly, the DIAG commands are written over the third and eleventh addresses at which the ON command and the OFF command were respectively written.

Then, the ON address and the OFF address are updated based on the ON phase and the OFF phase that were newly read out from the RAM 13. It is here assumed that the ON address is the same address as that prior to the update, and the OFF address is the ninth address of the command table 131. Also, the ON command and the OFF command are written over the contents of the updated ON address and OFF address, and the content C of the command table 131 as shown in the third stage of FIG. 5 is obtained.

Note that a configuration is also possible in which it is determined whether or not the ON addresses (or the OFF addresses) before and after the update match each other, and if the ON addresses (or the OFF addresses) match each other, the DIAG command and the ON command (or OFF command) are not written over the ON address (or the OFF address).

The following will describe the operation of the above-described switch circuit with reference to a flowchart illustrating the operation. The processing described below is executed by the CPU 11 in accordance with a control program stored in advance in the ROM 12.

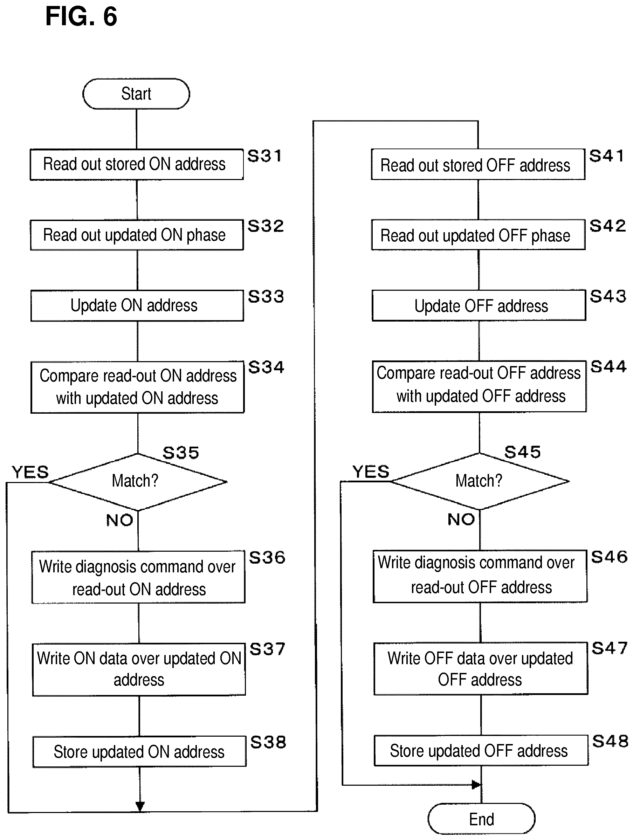

FIG. 6 is a flowchart illustrating a processing procedure of the CPU 11 that updates on/off control of the FET 181 with the switch circuit according to Embodiment 2 of the present invention.

The processing of FIG. 5 starts when an ON phase and/or an OFF phase stored in the RAM 13 is updated. In the flowchart that will be described below, "to overwrite a content of an address" is expressed simply as "to overwrite an address" (the same applies to the flowcharts of other embodiments that will be described later).

When the processing of FIG. 6 starts, the CPU 11 reads out, from the RAM 13, an ON address stored in, for example, step S14 of FIG. 4, that is, an address at which ON data was written prior to the update (step S31). Then, the CPU 11 newly reads out an updated ON phase from the RAM 13 (step S32), and updates an ON address over which the ON data is to be written based on the newly read-out ON phase (which corresponds to step S33: updating means). Then, the CPU 11 compares the ON address read out from the RAM 13 with the updated ON address (which corresponds to step S34: comparing means), and determines whether or not a result of the comparison shows that the ON addresses match each other (S35), and if the ON addresses match each other (YES in step S35), the procedure advances to step S41 (corresponding to disabling means), which will be described later.

If the two addresses determined by the comparison do not match each other (NO in step S35), the CPU 11 writes a diagnosis command over the ON address read out from the RAM 13 (which corresponds to step S36: second overwriting means), writes ON data over the diagnosis command written at the updated ON address (which corresponds to step S37: overwriting means), and stores the updated ON address in the RAM 13 (which corresponds to step S38: storing means). Note that, if, during calculation of an ON address, the ON address is stored in a register and the like (that corresponds to a storage section) of the CPU 11, the processing of step S38 will be omitted (the same applies to an OFF address that will be described later).

Then, the CPU 11 reads out, from the RAM 13, an OFF address that was stored in, for example, step S18 of FIG. 4, that is, an address at which OFF data was written prior to the update (step S41). Then, the CPU 11 newly reads out an updated OFF phase from the RAM 13 (step S42), and updates an OFF address over which the OFF data is to be written based on the newly read-out OFF phase (which corresponds to step S43: updating means). Then, the CPU 11 compares the OFF address read out from the RAM 13 with the updated OFF address (which corresponds to step S44: comparing means), and determines whether or not a result of the comparison shows that the OFF addresses match each other (step S45), and if the OFF addresses match each other (YES in step S45), the processing of FIG. 6 ends (which corresponds to disabling means).

If the two addresses determined by the comparison do not match each other (NO in step S45), the CPU 11 writes a diagnosis command over the ON address read out from the RAM 13 (which corresponds to step S46: second overwriting means), writes OFF data over the diagnosis command t written at the updated OFF address (which corresponds to step S47: overwriting means), and stores the updated OFF address in the RAM 13 (which corresponds to step S48: storing means), and the processing of FIG. 6 ends.

Note that, in the flowchart above, in steps S35 and S45, it is determined whether or not the ON addresses and the OFF addresses before and after the update match each other, but it is also possible to advance the procedure to step S36 and/or step S46, without performing the determination of step S35 and/or step S45.

Accordingly, by updating the address of the command table 131 at which the ON command and/or the OFF command are to be written, the phases at which the FET 181 is controlled to be turned on/off are updated at an appropriate time.

As described above, according to Embodiment 2, prior to updating phases at which the IPD 18 is controlled to be turned on/off, the non-updated transfer source address (ON address and/or OFF address) at which an ON command (ON data) and/or an OFF command (OFF data) was written is temporarily stored, and a DIAG (diagnosis) command is written over the content of the stored transfer source address. Then, the transfer source address from which the command is DMA-transferred to the IPD 18 is updated at a new phase at which the IPD 18 is to be controlled to be turned on and/or off. Then, when the transfer source address for ON control of the IPD 18 is updated, an ON command is written over the updated transfer source address, and when the transfer source address for OFF control of the IPD 18 is updated, an OFF command is written over the updated transfer source address.

Accordingly, when updating an ON address and/or OFF address at which ON data and/or OFF data is to be written, it is possible to easily update the phase at which the IPD 18 is controlled to be turned on and/or off, by writing a diagnosis command over the content of the ON address and/or OFF address prior to the update, and writing the ON data and/or the OFF data over the content of the ON address and/or OFF address that were/was updated in accordance with the overwriting.

Moreover, according to Embodiment 2, the ON address and/or OFF address prior to the update is stored in the RAM 13, and the stored ON address and/or OFF address and the corresponding updated ON address and/or OFF address are compared with each other, and writing of DIAG commands over the ON data and/or OFF data written at the addresses that match each other, and writing of ON data and/or OFF data over the DIAG commands are disabled.

Accordingly, if there is no change in the ON addresses and/or OFF addresses before and after update at the phase at which the IPD 18 is to be controlled to be turned on and/or off, it is possible to omit unnecessary writing to the command table 131.

### Embodiment 3

In contrast to Embodiment 1 that has an aspect in which an ON command and an OFF command are written only over the ON address and the OFF address in the command table 131 that respectively correspond to an ON phase and an OFF phase, Embodiment 3 has an aspect in which an ON command and an OFF command are written also over an address distanced from the ON address and the OFF address.

Because a hardware configuration of a switch circuit according to Embodiment 3 is the same as that of Embodiment 1, like reference numerals are given to the corresponding components and redundant descriptions are omitted.

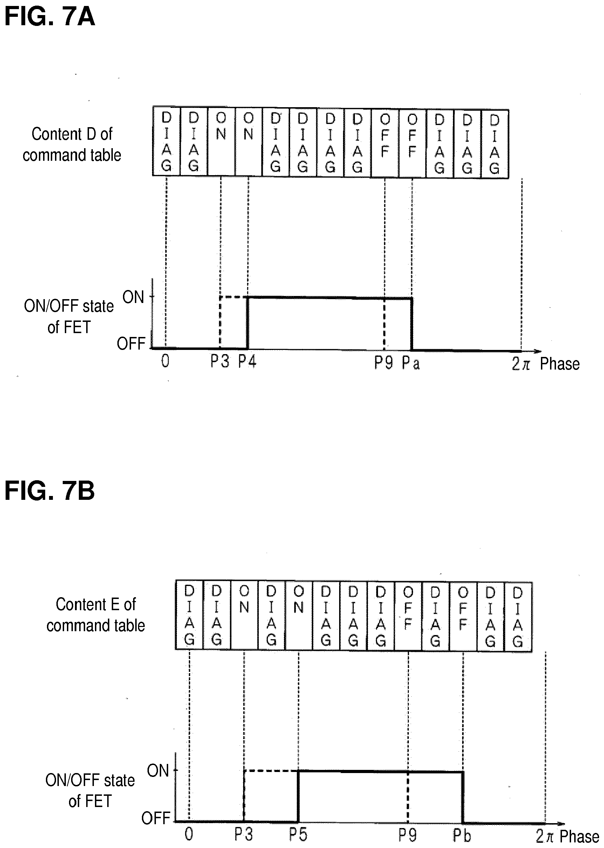

FIGS. 7A and 7B are diagrams illustrating correspondence between commands and on/off control of a FET 181 of the switch circuit according to Embodiment 3 of the present invention. In FIGS. 7A and 7B, the horizontal axis denotes phases in a period in which the FET 181 is controlled to be turned on/off. FIGS. 7A and 7B respectively show, in the upper stage thereof, content D and content E of the command table 131 that are for controlling the FET 181 to be turned on/off, and show in the lower stage thereof, the on/off states of the FET 181.

As shown in FIG. 7A, on/off control of the FET 181 is ensured, by writing an ON command and an OFF command respectively over the ON address and the OFF address that correspond to the ON phase and OFF phase at which the FET 181 is to be controlled to be turned on and off, and over addresses distanced from the address by one address.

For example, if the ON phase at which the FET 181 is to be controlled to be turned on is phase P3 (or P4), an ON command is written also over the address that corresponds to phase P4 (or P3). Accordingly, even if the FET 181 is not controlled to be turned on at phase P3, the likelihood of the FET 181 being controlled to be turned on at phase P4 will increase. Similarly, if the OFF phase at which the FET 181 is to be controlled to be turned off is phase P9 (or Pa), an OFF command is written also over the address that corresponds to phase Pa (or P9). Accordingly, even if the FET 181 is not controlled to be turned off at phase P9, the likelihood of the FET 181 being controlled to be turned off at phase Pa will increase.

Moving to FIG. 7B, on/off control of the FET 181 is ensured, by writing an ON command and an OFF command respectively over the addresses that correspond to the ON phase and the OFF phase at which the FET 181 is to be controlled to be turned on and off, and over addresses distanced from these addresses by two addresses or more.

For example, if the ON phase at which the FET 181 is to be controlled to be turned on is phase P3 (or P5), an ON command is written also over the address that corresponds to phase P5 (or P3). Accordingly, even if the FET 181 is not controlled to be turned on at phase P3, the likelihood of the FET 181 being controlled to be turned on at phase P5 will increase. Similarly, if the OFF phase at which the FET 181 is controlled to be turned off is phase P9 (or Pb), an OFF command is written also over the address that corresponds to phase Pb (or P9). Accordingly, even if the FET 181 is not controlled to be turned off at phase P9, the likelihood of the FET 181 being controlled to be turned off at phase Pb will increase.

The following will describe the operation of the above-described switch circuit with reference to a flowchart illustrating the operation. The processing described below is executed by the CPU 11 in accordance with a control program stored in advance in the ROM 12.

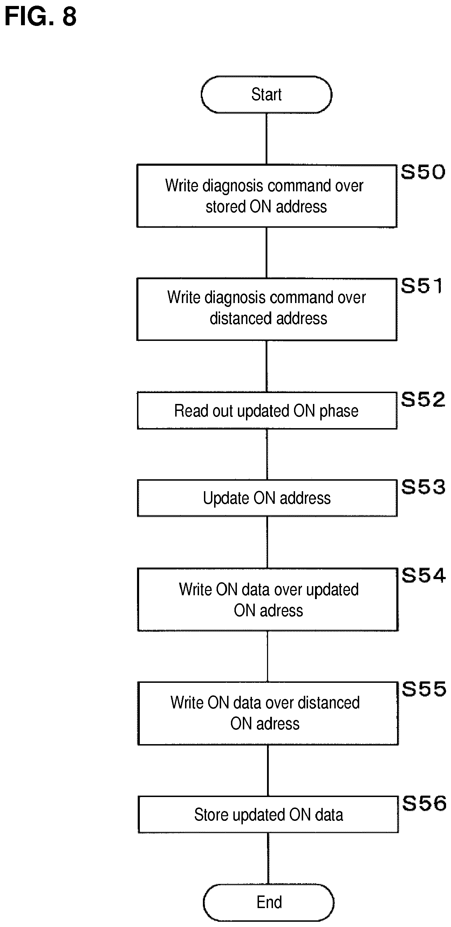

FIG. 8 is a flowchart illustrating a processing procedure of the CPU 11 that updates ON control of the FET 181 with the switch circuit according to Embodiment 3 of the present invention. The processing of FIG. 8 starts when an ON phase stored in the RAM 13 is updated.

When the processing of FIG. 8 starts, the CPU 11 writes a diagnosis command over an ON address stored in, for example, step S12 or S14 of FIG. 4, that is, an address at which ON data was written before the update (which corresponds to step S50: second overwriting means), and further writes a diagnosis command over the address distanced from the overwritten address by 1 position, or the address distanced from the overwritten address by two addresses or more (which corresponds to step S51: second overwriting means). The direction in which the address is distanced may be a direction in which the address count increases or the address count decreases. Then, the CPU 11 newly reads out an updated ON phase from the RAM 13 (step S52), and updates the ON address at which ON data is to be written, based on the newly read-out ON phase (which corresponds to step S53: updating means).

Then, the CPU 11 writes the ON data over the updated ON address (which corresponds to step S54: overwriting means), and further writes the ON data over the address distanced from the overwritten address by one address, or the address distanced from the overwritten address by two addresses or more (which corresponds to step S55: overwriting means). Then, the CPU 11 stores the updated ON address in the RAM 13 (which corresponds to step S56: storing means), and the procedure of FIG. 8 ends. Note that, if, during calculation of an ON address, the ON address is stored in a register or the like of the CPU 11, the processing of step S56 will be omitted.

Note that in the flowchart above, a case where an ON phase is updated, but the flowchart that shows the processing procedure of the CPU 11 that updates OFF control of the FET 181 when an OFF phase is updated is the same as that of FIG. 8. Specifically, the ON address, the ON phase, and the ON data of FIG. 8 may be replaced by an OFF address, an OFF phase, and OFF data.

As described above, according to Embodiment 3, when an ON command (ON data) is written over a DIAG command that was written at a calculated transfer source address (ON address), an ON command is written also over a DIAG command that was written at an address distanced to the front/rear from the calculated transfer source address by one address or more. Furthermore, when an OFF command (OFF data) is written over a DIAG command that was written at a calculated transfer source address (OFF address), an OFF command is written also over a DIAG command distanced to the front/rear from the calculated transfer source address by one address or more.

Accordingly, by writing either or both of ON data and OFF data two times, it is possible to reliably perform on/off control of the IPD 18.

### Embodiment 4

In contrast to Embodiments 1 to 3 that have an aspect in which a command and a DIAG command for controlling a FET 181 to be turned on/off are DMA-transferred, Embodiment 4 has an aspect in which a command and a DIA command for controlling the FET 181 to be turned on/off, as well as another control command are DMA-transferred to the IPD 18.

Because a hardware configuration of a switch circuit according to Embodiment 4 is the same as that of Embodiment 1, like reference numerals are given to the corresponding components and redundant descriptions are omitted.

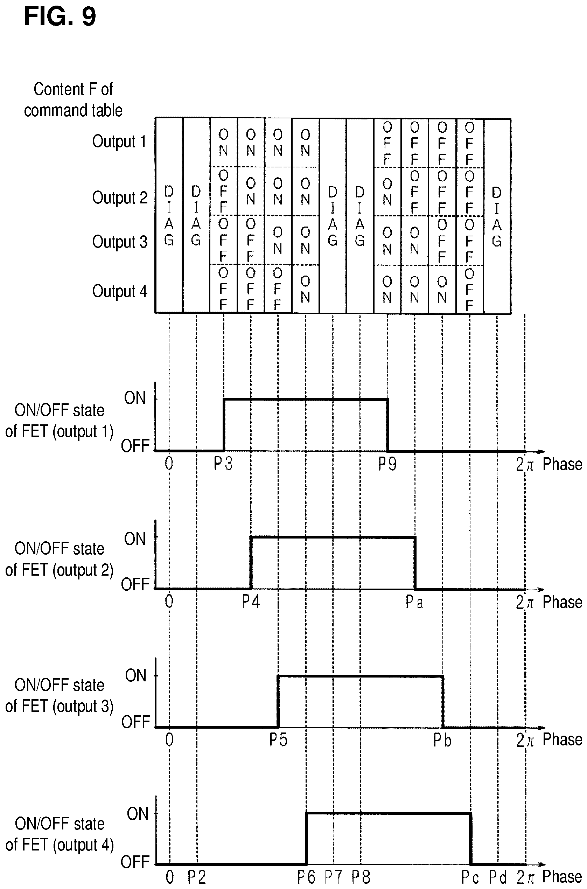

FIG. 9 is a diagram illustrating correspondence between commands and on/off control of FETs 181 of the switch circuit according to Embodiment 4 of the present invention. In FIG. 9, the horizontal axis denotes phases in a period in which the FETs 181 are controlled to be turned on/off, and the figure shows, from the upper stage thereof, content F in the command table 131 that is for controlling four FETs 181 to be turned on/off, and on/off states of the FETs 181 that correspond to output 1 to 4, in the stated order.

The content F of the command table 131 shown in the uppermost stage of FIG. 9 shows that the FETs 181 that correspond to the outputs 1 to 4 are controlled to be turned ON/OFF by 1/0 of the low-order 4 bits included in one output command. For example, the FET 181 that corresponds to the output 1 is controlled to be turned on at phase P3, and to be turned off at phase P9. Similarly, the FETs 181 that correspond to the outputs 2, 3, and 4 are respectively controlled to be turned on at phases P4, P5, and P6, and to be turned off at phases Pa, Pb, and Pc.

As in the example shown in FIG. 9, if, of phases 0 to 2n of one period, a range of phases at which none of the FETs 181 that correspond to the outputs 1 to 4 of the IPD 18 is controlled to be turned on/off is set in advance, DIAG commands will always be written in a range of addresses in the command table 131 that corresponds to the set range of phases. Specifically, the range of addresses includes the first, second, seventh, eighth, and thirteenth addresses in the command table 131. By storing such a range of addresses (corresponding to second storing means), and writing another control command for controlling the IPD 18 over the DIAG command that was written at any one of the addresses in the stored range (corresponding to third overwriting means), operations of the IPD 18 is controlled without affecting on/off control of the FETs 181.

That is, when the other overwritten control command is transferred to the SPI controller 17 with DMA-transfer, and is further received by the IPD 18 with SPI communication, the IPD 18 is controlled by the other control command. Examples of the other control command include a command to cancel the FET 181 held in a latched state, and a command to switch a sence current with respect to the outputs 1 to 4.

As described above, according to Embodiment 4, when a range of phases at which none of the four FETs 181, which are independently controlled to be turned on and off by one command, is controlled to be turned on/off is set in advance, a range of transfer source addresses from which transfer data is to be DMA-transferred to a switch in the set range of phases is stored in the RAM 13. DIAG (diagnosis) commands are always held in this range of transfer source addresses. In this state, when, for example, a control other than the on/off control is performed on the IPD 18, another control command that corresponds to the other control is written over the DIAG command that was written at a suitable address in the range of transfer source addresses stored in the RAM 13.

Accordingly, it is possible to perform another control on the IPD 18 without the need of searching a transfer source address at which another control command is allowed to be written over, and without affecting on/off control of the IPD 18.

### Embodiment 5

In contrast to Embodiment 4 that has an aspect in which a range of transfer source addresses at which a DIAG command is to always be held is stored, and another control command is written over the content of a suitable address within the stored range of the addresses, Embodiment 5 has an aspect in which a transfer source address over whose content an ON command or an OFF command is to be written, and a transfer source address over which another control command is to be written are separately and alternately prepared.

Because a hardware configuration of a switch circuit according to Embodiment 5 is the same as that of Embodiment 1, like reference numerals are given to the corresponding components and redundant descriptions are omitted.

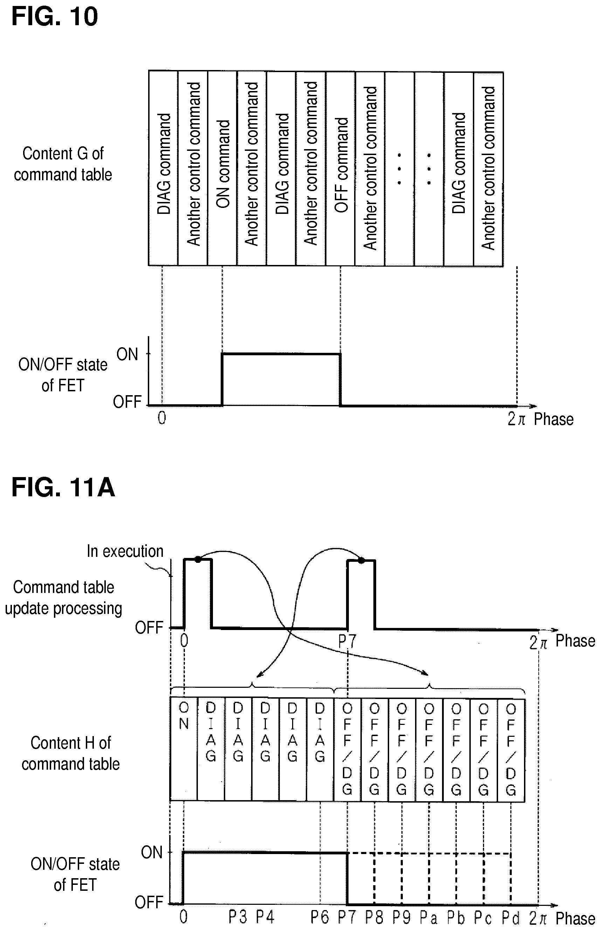

FIG. 10 is a diagram illustrating correspondence between commands and on/off control of a FET 181 of the switch circuit according to Embodiment 5 of the present invention. In FIG. 10, the horizontal axis denotes phases in a period in which the FET 181 is controlled to be turned on/off, and the figure shows, in the upper stage thereof, content G of the command table 131 that is for controlling the FET 181 to be turned on/off, and shows, in the lower stage thereof, an on/off state of the FET 181.

In Embodiment 5, for example, the size of the command table 131 is set as a size in which 200 commands can be written, and DIAG commands are written in advance in the entire region of the command table 131 (corresponding to writing means). When an ON command or an OFF command is written over the DIAG commands in the command table 131, an address at which overwriting is to be performed is calculated from 100 odd-numbered addresses included in the command table 131 (corresponding to second calculating means). Accordingly, the accuracy of the duty ratio when the IPD 18 is controlled to be turned on/off is 1%. Furthermore, when another control command is written over the DIAG command in the command table 131, overwriting is performed on the content of a suitable address of 100 even-numbered addresses (corresponding to fourth overwriting means). The other control command may also be written over the contents of a plurality of even-numbered addresses.

Accordingly, by separating an address over which a command for controlling the FET 181 to be turned on/off is to be written from an address over which a control command other than a DIAG command is to be written, it is possible to give a suitable control command to the IPD 18 at a suitable phase in a period in which the FET 181 is controlled to be turned on/off.

Note that a configuration is also possible in which another control command is written over the contents of odd-numbered addresses, and an ON command or an OFF command is written over the contents of even-numbered addresses.

As described above, according to Embodiment 5, both addresses over whose contents an ON command (ON data) and an OFF command (OFF data) are respectively to be written are calculated from odd-numbered addresses or even-numbered addresses in the command table 131. If, in this state, for example, a control other than on/off control is performed on the IPD 18, and an ON command and an OFF command are written over the contents of odd-numbered addresses, another control command is written over the DIAG command that was written at a suitable address over which an even-numbered command is to be written. Furthermore, if an ON command and an OFF command are written over the contents of even-numbered addresses, another control command will be written over the DIAG command that was written at a suitable address over which an odd-numbered command is to be written.

Accordingly, it is possible to perform another control on the IPD 18 as needed, without the need of searching a transfer source address at which another control command is allowed to be written over, and without affecting on/off control of the IPD 18.

Furthermore, according to Embodiment 5, it is possible to control the IPD 18 to be turned on/off with the duty ratio of the same accuracy as the case of Embodiment 1 in which the accuracy of the duty ratio when the IPD 18 is controlled to be turned on/off is set to 1%, by setting the size of the command table 131 as being twice larger than that of Embodiment 1.

### Embodiment 6

In contrast to Embodiments 1 to 5 have an aspect in which a timing to update a content of the command table 131 is not clearly indicated, Embodiment 6 has an aspect in which contents of different regions in the command table 131 are updated at timings of a first half and a second half of a period in which the FET 181 is controlled to be turned on/off.

Because a hardware configuration of a switch circuit according to Embodiment 6 is the same as that of Embodiment 1, like reference numerals are given to the corresponding components and redundant descriptions are omitted.

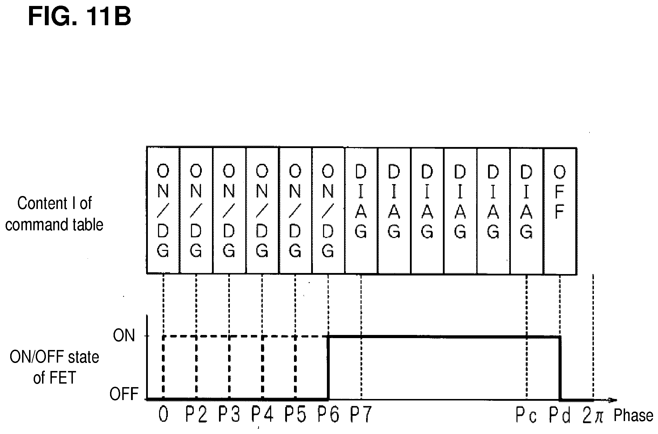

FIGS. 11A and 11B are diagrams illustrating correspondence between commands and on/off control of the FET 181 of a switch circuit according to Embodiment 6 of the present invention. In FIGS. 11A and 11B, the horizontal axis denotes phases in a period in which the FET 181 is controlled to be turned on/off. FIGS. 11A and 11B respectively show on/off states of the FET 181 in the lower stages thereof, and show content H and content I of the command table 131 that are for controlling the FET 181 to be turned on/off in the stages above. The uppermost stage of FIG. 11A shows an execution state of updating processing for updating the content of the command table 131.

Meanwhile, DMA transfer in which an address in the command table 131 is set as a transfer source address, and updating processing for updating the command table 131 by the CPU 11 cannot directly compete against each other. However, if, for example, the CPU 11 updates an ON address, and the contents of the ON addresses before and after update are DMA-transferred after a DIAG command was written over the content of the non-updated ON address and before an ON command is written over the updated ON address, the FET 181 will not be turned on in this period, and on/off control of the FET 181 is not possible for one period. In order to avoid this, it is sufficient to ensure that, during a period in which the CPU 11 updates one partial region (or another partial region) of the command table 131, the one partial region (or the other partial region) is not subjected to DMA transfer.

As shown in the uppermost stage of FIG. 11A, processing for updating the entire region of the command table 131 is divided into, for example, processes that are started at two places of phases 0 and P7 in a period in which the FET 181 is controlled to be turned on/off. Then, a boundary between regions that are updated by these two updating processes is set at, for example, the address that corresponds to an intermediate phase betweenphases P6 and P7. In other words, in the updating process that is started at phase 0, contents of the addresses located on the rear side of the boundary at the address are updated (corresponding to fifth overwriting means). Then, in the updating process that is started at phase P7, contents of the addresses located on the front side of the boundary at the address are updated (corresponding to fifth overwriting means). Accordingly, the updating processing for updating contents of the command table 131 and the DMA transfer are prevented from interfering with each other.

Note that the phases at which these two updating processes are to be started are not limited to phases 0 and P7, as long as the two updating processes are in execution and regions that are respectively being subjected to the processes are not DMA-transferred, and the boundary of the address is also not limited to the address that corresponds to an intermediate phase between phases P6 and P7. For example, the two updating processes may be started temporally at equal intervals in a period in which the FET 181 is controlled to be turned on/off. Furthermore, the updating processes may be started three times or more in the period, and in this case, the addresses of the boundaries for regions to be subjected to updating of the updating process may be set appropriately based on this count of the processes that are to be started.

The following will describe a case in which one of the updating processes to be started at phases 0 and P7 can be omitted.

As shown in the lowermost stage of FIG. 11A, if, for example, the ON phase at which the FET 181 is controlled to be turned on is fixed to phase 0, and the OFF phase at which the FET 181 is controlled to be turned off changes between phases P7 to Pd, the updating process to be started at phase P7 can be omitted. That is, of the commands written in the command table 131, the commands of the first, and the second to sixth addresses that respectively correspond to phases P0, and P2 to P6 are fixed to an ON command, and a DIAG command, and thus these commands do not need to be updated.

In contrast, one of the commands of the seventh to thirteenth addresses that correspond to phases P7 to Pd is an OFF command, and the remaining commands are DIAG commands, and the type of command depends on the OFF phase at which the FET 181 is to be controlled to be turned off (denoted by "OFF/DG" in the figure). Accordingly, updating of a command by the updating process to be started at phase P0 needs to be performed. FIG. 11A shows the state in which, when the phase at which a DIAG command is updated to an OFF command changes from phase P7 to phase Pd, the phase at which the FET 181 is controlled to be turned off changes from phase P7 to phase Pd.

Moving to FIG. 11B, if, for example, the OFF phase at which the FET 181 is controlled to be turned off is fixed to phase Pd, and the ON phase at which the FET 181 is controlled to be turned on changes between phases 0 to P6, the updating process to be started at phase P0 can be omitted. That is, of the commands written in the command table 131, the commands of the seventh to twelfth, and thirteenth addresses that respectively correspond to phases P7 to Pc, and Pd are fixed to a DIAG command and an OFF command, and thus these commands do not need to be updated.

In contrast, one of the commands at the first to sixth addresses that correspond to phases P0 to P6 is an ON command, and the remaining commands are DIAG commands, and the type of command depends on the OFF phase at which the FET 181 is to be controlled to be turned off (denoted by "ON/DG" in the figure). Accordingly, updating of a command by the updating process to be started at phase P7 needs to be performed. FIG. 11B shows the state in which, when the phase at which a DIAG command is updated to an ON command changes from phase 0 to phase P6, the phase at which the FET 181 is controlled to be turned on changes from phase 0 to phase P6.

As described above, according to Embodiment 6, the processing for updating the commands in the command table 131 is divided into two updating processes that are started at phases 0 and P7, and the boundary between the commands to be updated in the divided updating processes is set at the address that corresponds to the middle of phases P6 and P7. Then, while the commands located on the front side of the set boundary are DMA-transferred, another command is written over a suitable command located on the rear side of the set boundary and is updated. Furthermore, while the commands located on the rear side of the set boundary are DMA-transferred, another command is written over a suitable command located on the front side of the set boundary and is updated.

Accordingly, it is possible to update a phase at which the IPD 18 is controlled to be turned on/off, without affecting on/off control of the IPD 18.

Furthermore, according to Embodiment 6, a starting period in which processing for updating commands in the command table 131 is started is set as being just a half of a PWM period in which the IPD 18 is controlled to be turned on/off, and thereby commands in the regions, on the front side and the rear side, of the command table 131 are updated by processes that are started in the respective starting periods of even numbered and odd numbered addresses for example, making it possible to simplify the design of software, and also to reliably update all the commands in the command table 131.

The embodiments disclosed here are exemplary in all respect and are to be construed as not limiting. The scope of the present invention is defined not in the sense of the description above but the claims, and is intended to include all modifications within the sense and scope equivalent to the claims. Furthermore, the technical features described in the embodiments can be combined with each other.

### Reference Signs List

- 11: CPU
- 12: ROM
- 13: RAM
- 131: Command table
- 132: Response table
- 14: Timer
- 15: DMA controller
- 16: Interrupt controller
- 17: SPI controller
- 18: IPD
- 181: FET
- 19: Load

## Claims

1. A switch on/off control method for being performed in a switch circuit that is provided with: a DMA controller (15) for DMA-transferring all of a plurality of pieces of transfer data written in a predetermined region of a memory (13) in a predetermined period; and a switch (18) that is controlled to be turned on/off based on the transfer data from the DMA controller (15), **characterized in that** the transfer data is ON data for use in controlling the switch (18) to be turned on, OFF data for use in controlling the switch (18) to be turned off, or third data for use other than in controlling the switch (18) to be turned on/off,
the third data is written in advance in the entire predetermined region,
transfer source addresses from which the transfer data is DMA-transferred to the switch (18) at a phase at which the switch (18) is to be controlled to be turned on and a phase at which the switch (18) is to be controlled to be turned off are respectively calculated, the phases being included in the predetermined period, and
the ON data and the OFF data are respectively written over the third data that was written at the calculated transfer source addresses.

2. The switch on/off control method according to claim 1,
wherein the third data is written over a content of the transfer source address at which the ON data or OFF data was written,
the transfer source address from which the transfer data is DMA-transferred to the switch (18) is updated at the phase at which the switch (18) is to be controlled to be turned on (or phase at which the switch (18) is to be controlled to be turned off), and
the ON data or OFF data is written over the third data that was written at the updated transfer source address.

3. The switch on/off control method according to claim 2,
wherein a storage section is prepared,
the transfer source address at which the ON data or OFF data was written is stored in the storage section,
the transfer source address stored in the storage section, and the updated transfer source address are compared with each other, and
if a result of the comparison shows that the transfer source addresses match each other, overwriting of the third data and overwriting of the ON data or OFF data are disabled.

4. The switch on/off control method according to any one of claims 1 to 3,
wherein the ON data or OFF data is written over the third data that was written at a calculated or updated transfer source address, and an address distanced from the calculated or updated transfer source address.

5. The switch on/off control method according to any one of claims 1 to 4,
wherein a second storage section is prepared,
the switch circuit is provided with a plurality of the switches (18),
the plurality of switches (18) are configured to be individually controlled to be turned on and off by one of the pieces of transfer data from the DMA controller (15),
a range of phases at which none of the switches (18) is controlled to be turned on/off is set in advance in the predetermined period,
a range of transfer source addresses from which the transfer data is DMA-transferred to the switch (18) within the set range of phases is stored in the second storage section,
another piece of third data is written over the third data that was written at a suitable address within the range of transfer source addresses that was stored in the second storage section.

6. The switch on/off control method according to any one of claims 1 to 4,
wherein transfer source addresses from which the transfer data is DMA-transferred to the switch (18) at the phase at which the switch (18) is to be controlled to be turned on, and the phase at which the switch (18) is to be controlled to be turned off are respectively calculated from odd-numbered or even-numbered addresses in the predetermined region, and
another piece of third data is written over the third data that was written at a suitable address of even-numbered or odd-numbered addresses in the predetermined region.

7. The switch on/off control method according to any one of claims 1 to 6,
wherein a boundary between pieces of transfer data that are to be DMA-transferred sequentially in the predetermined region is set in advance, and
while a piece of transfer data located on a front side or rear side of the boundary is DMA-transferred, another piece of transfer data is written over a suitable piece of transfer data on the rear side or front side.

8. A switch circuit comprising:
a DMA controller (15) for DMA transferring all of a plurality of pieces of transfer data written in a predetermined region of a memory (13) in a predetermined period, and a switch (18) that is controlled to be turned on/off based on the transfer data from the DMA controller (15), **characterized in that** the transfer data is ON data for use in controlling the switch (18) to be turned on, OFF data for use in controlling the switch (18) to be turned off, or third data for use other than in controlling the switch (18) to be turned on/off, and
the switch circuit further comprises:
writing means for writing the third data in the entire predetermined region;
calculating means for calculating transfer source addresses from which the transfer data is DMA-transferred to the switch (18) at a phase at which the switch (18) is to be controlled to be turned on and a phase at which the switch (18) is to be controlled to be turned off, the phases being included in the predetermined period; and
overwriting means for respectively writing the ON data and OFF data over the third data that was written at the transfer source addresses calculated by the calculating means.

9. The switch circuit according to claim 8, further comprising:
second overwriting means for writing the third data over a content of the transfer source address at which the ON data or OFF data was written; and
updating means for updating the transfer source address from which the transfer data is DMA-transferred to the switch (18) at the phase at which the switch (18) is to be controlled to be turned on or a phase at which the switch (18) is to be controlled to be turned off,
wherein the overwriting means is configured to write the ON data or OFF data over the third data that was written at the transfer source address updated by the updating means.

10. The switch circuit according to claim 9, further comprising:
storing means for storing the transfer source address at which the ON data or OFF data was written;
comparing means for comparing the transfer source address stored by the storing means and the transfer source address updated by the updating means; and
disabling means for disabling overwriting of the third data and overwriting of the ON data or OFF data if a result of the comparison by the comparing means shows that the transfer source addresses match each other.

11. The switch circuit according to any one of claims 8 to 10,
wherein the overwriting means is configured to write the ON data (of OFF data) over third data that was written at the transfer source address that was calculated by the calculating means or updated by the updating means, and an address distanced from the calculated or updated transfer source address.

12. The switch circuit according to any one of claims 8 to 11,
wherein the switch circuit is provided with a plurality of the switches (18),
the plurality of switches (18) are configured to be individually controlled to be turned on and off by one of the pieces of transfer data from the DMA controller (15), and
a range of phases at which none of the switches (18) is controlled to be turned on/off is set in advance in the predetermined period,
the switch circuit further comprises:
second storing means for storing a range of transfer source addresses from which the transfer data is DMA-transferred to the switch (18) within the set range of phases; and
third overwriting means for writing another piece of third data over the third data that was written at a suitable address within the range of transfer source addresses that was stored by the second storing means.

13. The switch circuit according to any one of claims 8 to 11, further comprising:
second calculating means for calculating transfer source addresses from which the transfer data is DMA-transferred to the switch (18) at the phase at which the switch (18) is to be controlled to be turned on and the phase at which the switch (18) is to be controlled to be turned off, from odd-numbered or even-numbered addresses in the predetermined region; and
fourth overwriting means for writing another piece of third data over the third data that was written at a suitable address of even-numbered or odd-numbered addresses in the predetermined region.

14. The switch circuit according to any one of claims 8 to 13,
wherein a boundary between pieces of transfer data that are to be DMA-transferred sequentially in the predetermined region is set in advance, and
the switch circuit further comprises fifth overwriting means for writing, while a piece of transfer data located on a front side or rear side of the boundary is DMA-transferred, another piece of transfer data over a suitable piece of transfer data on the rear side or front side.

## Patentansprüche

1. Verfahren zum Steuern eines Ein/Aus-Schaltens eines Schalterstromkreises, welcher aufweist: einen DMA-Controller (15) zum DMA-Übertragen aller von mehreren Übertragungsdaten, die in einen vorbestimmten Bereich eines Speichers (13) während eines vorbestimmten Zeitintervalls geschrieben wurden; und einen Schalter (18), der zum Ein/Aus-Schalten in Abhängigkeit der Übertragungsdaten des DMA-Controllers (15) angesteuert wird,
**dadurch gekennzeichnet, dass**
die Übertragungsdaten EIN-Daten zum Verwenden beim Ansteuern des Schalters (18) zum Einschalten sind, AUS-Daten zum Verwenden beim Ansteuern des Schalters (18) zum Ausschalten sind, oder dritte Daten zum anderweitigen Verwenden als dem Steuern des Ein/Aus-Schaltens des Schalters (18) sind,
die dritten Daten im Voraus in den gesamten vorbestimmten Bereich geschrieben werden,
Übertragungsquelladressen, von denen die Übertragungsdaten bei einer Phase, zu welcher der Schalter (18) zum Einschalten angesteuert wird und bei einer Phase, zu welcher der Schalter (18) zum Ausschalten angesteuert wird, zu dem Schalter (18) DMA-übertragen werden, jeweils berechnet werden, wobei die Phasen in dem vorbestimmten Zeitintervall enthalten sind, und
die EIN-Daten und die AUS-Daten jeweils über die bei den berechneten Übertragungsquelladressen geschriebenen dritten Daten geschrieben werden.

2. Verfahren zum Steuern des Ein/Aus-Schaltens nach Anspruch 1, wobei
die dritten Daten über einen Inhalt der Übertragungsquelladresse geschrieben werden, bei welcher die EIN-Daten oder AUS-Daten geschrieben wurden,
die Übertragungsquelladresse, von welcher die Übertragungsdaten an den Schalter (18) DMA-übertragen werden, zu der Phase aktualisiert wird, zu welcher der Schalter (18) zum Einschalten angesteuert wird (oder zu welcher der Schalter (18) zum Ausschalten angesteuert wird), und
die EIN-Daten oder die AUS-Daten werden über die bei der aktualisierten Übertragungsquelladresse geschriebenen dritten Daten geschrieben.

3. Verfahren zum Steuern des Ein/Aus-Schaltens nach Anspruch 2, wobei ein Speicherabschnitt bereitgestellt wird,
die Übertragungsquelladresse, bei welcher die EIN-Daten oder die AUS-Daten geschrieben waren, in dem Speicherabschnitt gespeichert wird,
die Übertragungsquelladresse, die in dem Speicherabschnitt gespeichert ist, und die aktualisierte Übertragungsquelladresse miteinander verglichen werden, und
falls das Ergebnis des Vergleichs ergibt, dass die Übertragungsquelladressen übereinstimmen, das Überschreiben der dritten Daten und das Überschreiben der EIN-Daten oder der AUS-Daten gestoppt wird.

4. Verfahren zum Steuern des Ein/Aus-Schaltens nach einem der Ansprüche 1 bis 3, wobei
die EIN-Daten oder die AUS-Daten über die bei einer berechneten oder aktualisierten Übertragungsquelladresse und eine von dieser entfernten Adresse geschriebenen dritten Daten geschrieben werden.

5. Verfahren zum Steuern des Ein/Aus-Schaltens nach einem der Ansprüche 1 bis 4, wobei
ein zweiter Speicherabschnitt bereitgestellt wird,
der Schalterstromkreis mehrere der Schalter (18) aufweist,
die Schalter (18) dazu eingerichtet sind, einzeln mittels eines Satzes der Übertragungsdaten von dem DMA-Controller (15) zum Ein- und Ausschalten angesteuert zu werden,
ein Phasenbereich, zu dem keiner der Schalter (18) zum Ein/Aus-Schalten angesteuert wird, im Voraus während des vorbestimmten Zeitintervalls festgelegt wird,
ein Bereich von Übertragungsquelladressen, von welchen die Übertragungsdaten innerhalb des festgelegten Phasenbereichs an den Schalter (18) DMA-übertragen werden, in dem zweiten Speicherabschnitt gespeichert wird,
weitere dritte Daten über die dritten Daten geschrieben werden, die an einer geeigneten Adresse innerhalb des Bereichs von Übertragungsquelladressen geschrieben war, die in dem zweiten Speicherabschnitt gespeichert wurden.

6. Verfahren zum Steuern des Ein/Aus-Schaltens nach einem der Ansprüche 1 bis 4, wobei
Übertragungsquelladressen, von denen die Übertragungsdaten bei der Phase, zu welcher der Schalter (18) zum Einschalten angesteuert wird und bei der Phase, zu welcher der Schalter (18) zum Ausschalten angesteuert wird, zu dem Schalter (18) DMA-übertragen werden, jeweils von ungeradzahligen oder geradzahligen Adressen des vorbestimmten Bereichs berechnet werden, und
weitere dritte Daten über die dritten Daten geschrieben werden, die an einer geeigneten Adresse der geradzahligen oder ungeradzahligen Adressen des vorbestimmten Bereichs geschrieben waren.

7. Verfahren zum Steuern des Ein/Aus-Schaltens nach einem der Ansprüche 1 bis 6, wobei
eine Grenze zwischen den Übertragungsdaten, die zum sequenziellen DMA-Übertragen bestimmt sind, in dem vorbestimmten Bereich im Voraus festgelegt wird, und
während Übertragungsdaten, die vor oder hinter der Grenze liegen, DMA-übertragen werden, weitere Übertragungsdaten über geeignete Übertragungsdaten hinter oder vor der Grenze geschrieben werden.

8. Schalterstromkreis, aufweisend:
einen DMA-Controller (15) zum DMA-Übertragen aller von mehreren Übertragungsdaten in einem vorbestimmten Bereich eines Speichers (13) in einem vorbestimmten Zeitintervall und einen Schalter (18), der zum Ein/AusSchalten in Abhängigkeit der Übertragungsdaten des DMA-Controllers (15) angesteuert wird,
**dadurch gekennzeichnet, dass**
die Übertragungsdaten EIN-Daten zum Verwenden beim Ansteuern des Schalters (18) zum Einschalten sind, AUS-Daten zum Verwenden beim Ansteuern des Schalters (18) zum Ausschalten sind, oder dritte Daten zum anderweitigen Verwenden als dem Steuern des Ein/Aus-Schaltens des Schalters (18) sind,
der Schalterstromkreis ferner umfasst:
Schreibmittel zum Schreiben der dritten Daten in den gesamten vorbestimmten Bereich;
Berechnungsmittel zum Berechnen von Übertragungsquelladressen, von denen die Übertragungsdaten bei einer Phase, zu welcher der Schalter (18) zum Einschalten angesteuert wird und bei einer Phase, zu welcher der Schalter (18) zum Ausschalten angesteuert wird, zu dem Schalter (18) DMA-übertragen werden, wobei die Phasen in dem vorbestimmten Zeitintervall enthalten sind; und
Überschreibmittel zum jeweiligen Schreiben der EIN-Daten und der AUS-Daten über die dritten Daten, die bei den von dem Berechnungsmittel berechneten Übertragungsquelladressen geschrieben waren.

9. Schalterstromkreis gemäß Anspruch 8, ferner aufweisend:
zweite Überschreibmittel zum Schreiben der dritten Daten über einen Inhalt der Übertragungsquelladressen, bei denen EIN-Daten oder AUS-Daten geschrieben waren; und
Aktualisierungsmittel zum Aktualisieren der Übertragungsquelladressen von denen die Übertragungsdaten bei der Phase, zu welcher der Schalter (18) zum Einschalten angesteuert wird und bei der Phase, zu welcher der Schalter (18) zum Ausschalten angesteuert wird, zu dem Schalter (18) DMA-übertragen werden,
wobei das Überschreibmittel dazu eingerichtet ist, die EIN-Daten oder die AUS-Daten über die dritten Daten zu schreiben, die bei der von dem Aktualisierungsmittel aktualisierten Übertragungsquelladresse geschrieben waren.

10. Schalterstromkreis gemäß Anspruch 9, ferner aufweisend:
Speichermittel zum Speichern der Übertragungsquelladresse bei welcher die EIN-Daten oder die AUS-Daten geschrieben wurden;
Vergleichsmittel zum Vergleichen der von dem Speichermittel gespeicherten Übertragungsquelladresse mit der von dem Aktualisierungsmittel aktualisierten Übertragungsquelladresse, und
Deaktivierungsmittel zum Stoppen des Überschreibens der dritten Daten und des Überschreibens der EIN-Daten oder der AUS-Daten falls das Ergebnis des Vergleichs ergibt, dass die Übertragungsquelladressen übereinstimmen.

11. Schalterstromkreis nach einem der Ansprüche 8 bis 10, wobei
das Überschreibmittel dazu eingerichtet ist, die EIN-Daten (oder die AUS-Daten) über die dritten Daten, die bei der von dem Berechnungsmittel berechneten oder von dem Aktualisierungsmittel aktualisierten Übertagungsquelladresse geschrieben waren, und bei einer Adresse, die von der berechneten oder aktualisierten Übertragungsquelladresse entfernt ist, zu schreiben.

12. Schalterstromkreis nach einem der Ansprüche 8 bis 11, wobei
der Schalterstromkreis mehrere Schalter (18) aufweist,
die Schalter (18) dazu eingerichtet sind, einzeln mittels eines Satzes der Übertragungsdaten von dem DMA-Controller (15) zum Ein- und Ausschalten angesteuert zu werden, und
ein Phasenbereich, zu dem keiner der Schalter (18) zum Ein/Aus-Schalten angesteuert wird, im Voraus während des vorbestimmten Zeitintervalls festgelegt wird,
der Schalterstromkreis ferner aufweist:
zweite Speichermittel zum Speichern eines Bereichs von Übertragungsquelladressen, von welchen die Übertragungsdaten innerhalb des festgelegten Phasenbereichs an den Schalter (18) DMA-übertragen werden, und
dritte Überschreibmittel zum Schreiben von weiteren dritten Daten über die dritten Daten, die an einer geeigneten Adresse innerhalb des Bereichs von Übertragungsquelladressen geschrieben waren, die in dem zweiten Speichermittel gespeichert wurden.

13. Schalterstromkreis nach einem der Ansprüche 8 bis 11, ferner aufweisend:
zweite Berechnungsmittel zum Berechnen von ungeradzahligen oder geradzahligen Adressen des vorbestimmten Bereichs von Übertragungsquelladressen, von denen Übertragungsdaten bei der Phase, zu welcher der Schalter (18) zum Einschalten angesteuert wird und bei der Phase, zu welcher der Schalter (18) zum Ausschalten angesteuert wird, zu dem Schalter (18) DMA-übertragen werden, und
vierte Überschreibmittel zum Schreiben von weiteren dritten Daten über die dritten Daten, die an einer geeigneten Adresse der geradzahligen oder ungeradzahligen Adressen des vorbestimmten Bereichs geschrieben waren.

14. Schalterstromkreis nach einem der Ansprüche 8 bis 13, wobei
eine Grenze zwischen den Übertragungsdaten, die zum sequenziellen DMA-übertragen bestimmt sind, in dem vorbestimmten Bereich im Voraus festgelegt wird, und
der Schalterstromkreis fünfte Überschreibmittel aufweist, die dazu eingerichtet sind, während Übertragungsdaten, die vor oder hinter der Grenze liegen, DMA-übertragen werden, weitere Übertragungsdaten über geeignete Übertragungsdaten hinter oder vor der Grenze zu schreiben.

## Revendications

1. Procédé de commande de déblocage/blocage de commutateur à mettre en oeuvre dans un circuit de commutation qui est pourvu de : un contrôleur de DMA (15) destiné à transférer par accès direct en mémoire (DMA, direct memory access) la totalité d'une pluralité de données de transfert écrites dans une région prédéterminée de mémoire (13) au cours d'une période prédéterminée ; et un commutateur (18) qui est commandé pour être débloqué/bloqué sur la base des données de transfert provenant du contrôleur de DMA (15),
**caractérisé en ce que** :
les données de transfert sont des données ON (déblocage) destinées à être utilisées pour commander le commutateur (18) afin de le débloquer, des données OFF (blocage) destinées à être utilisées pour commander le commutateur (18) afin de le bloquer, ou des troisièmes données destinées à être utilisées à d'autres fins que pour commander le commutateur (18) afin de le débloquer/bloquer,
les troisièmes données sont écrites à l'avance dans toute la région prédéterminée,
des adresses sources de transfert à partir desquelles les données de transfert sont transférées par DMA au commutateur (18) à une phase à laquelle le commutateur (18) doit être commandé pour être débloqué et à une phase à laquelle le commutateur (18) doit être commandé pour être bloqué sont respectivement calculées, les phases étant incluses dans la période prédéterminée, et
les données ON et les données OFF sont respectivement écrites par-dessus les troisièmes données qui ont été écrites aux adresses sources de transfert calculées.

2. Procédé de commande de déblocage/blocage de commutateur selon la revendication 1,
dans lequel les troisièmes données sont écrites par-dessus un contenu de l'adresse source de transfert à laquelle les données ON ou les données OFF ont été écrites,
l'adresse source de transfert à partir de laquelle les données de transfert sont transférées par DMA au commutateur (18) est mise à jour à la phase à laquelle le commutateur (18) doit être commandé pour être débloqué (ou à la phase à laquelle le commutateur (18) doit être commandé pour être bloqué), et
les données ON ou les données OFF sont écrites par-dessus les troisièmes données qui ont été écrites à l'adresse source de transfert mise à jour.

3. Procédé de commande de déblocage/blocage de commutateur selon la revendication 2,
dans lequel une section de stockage est préparée,
l'adresse source de transfert à laquelle les données ON ou les données OFF ont été écrites est stockée dans la section de stockage,
l'adresse source de transfert stockée dans la section de stockage et l'adresse source de transfert mise à jour sont comparées entre elles, et
s'il ressort d'un résultat de la comparaison que les adresses sources de transfert concordent entre elles, l'écrasement des troisièmes données et l'écrasement des données ON ou des données OFF sont désactivés.

4. Procédé de commande de déblocage/blocage de commutateur selon l'une quelconque des revendications 1 à 3,
dans lequel les données ON ou les données OFF sont écrites par-dessus les troisièmes données qui ont été écrites à une adresse source de transfert calculée ou mise à jour, et à une adresse à distance de l'adresse source de transfert calculée ou mise à jour.

5. Procédé de commande de déblocage/blocage de commutateur selon l'une quelconque des revendications 1 à 4,
dans lequel une seconde section de stockage est préparée,
le circuit de commutation est pourvu d'une pluralité des commutateurs (18),
les multiples commutateurs (18) sont conçus pour être commandés individuellement afin d'être débloqués et bloqués par l'une des données de transfert provenant du contrôleur de DMA (15),
une plage de phases auxquelles aucun des commutateurs (18) n'est commandé pour être débloqué/bloqué est définie à l'avance dans la période prédéterminée, une plage d'adresses sources de transfert à partir desquelles les données de transfert sont transférées par DMA au commutateur (18) à l'intérieur de la plage définie de phases est stockée dans la seconde section de stockage,
une autre troisième donnée est écrite par-dessus les troisièmes données qui ont été écrites à une adresse appropriée à l'intérieur de la plage d'adresses sources de transfert qui a été stockée dans la seconde section de stockage.

6. Procédé de commande de déblocage/blocage de commutateur selon l'une quelconque des revendications 1 à 4,
dans lequel des adresses sources de transfert à partir desquelles les données de transfert sont transférées par DMA au commutateur (18) à la phase à laquelle le commutateur (18) doit être commandé pour être débloqué, et à la phase à laquelle le commutateur (18) doit être commandé pour être bloqué sont respectivement calculées à partir d'adresses à numéros impairs ou à numéros pairs dans la région prédéterminée, et
une autre troisième donnée est écrite par-dessus les troisièmes données qui ont été écrites à une adresse appropriée des adresses à numéros pairs ou à numéros impairs dans la région prédéterminée.

7. Procédé de commande de déblocage/blocage de commutateur selon l'une quelconque des revendications 1 à 6,
dans lequel une limite entre des données de transfert qui doivent être transférées par DMA de façon séquentielle dans la région prédéterminée est définie à l'avance, et
pendant qu'une donnée de transfert se trouvant d'un côté avant ou d'un côté arrière de la limite est transférée par DMA, une autre donnée de transfert est écrite par-dessus une donnée de transfert appropriée du côté arrière ou du côté avant.

8. Circuit de commutation comprenant :
un contrôleur de DMA (15) destiné à transférer par DMA la totalité d'une pluralité de données de transfert écrites dans une région prédéterminée de mémoire (13) au cours d'une période prédéterminée, et un commutateur (18) qui est commandé pour être débloqué/bloqué sur la base des données de transfert provenant du contrôleur de DMA (15),
**caractérisé en ce que** :
les données de transfert sont des données ON destinées à être utilisées pour commander le commutateur (18) afin de le débloquer, des données OFF destinées à être utilisées pour commander le commutateur (18) afin de le bloquer, ou des troisièmes données destinées à être utilisées à d'autres fins que pour commander le commutateur (18) afin de le débloquer/bloquer, et
le circuit de commutation comprend en outre :
un moyen d'écriture destiné à écrire les troisièmes données dans toute la région prédéterminée
un moyen de calcul destiné à calculer des adresses sources de transfert à partir desquelles les données de transfert sont transférées par DMA au commutateur (18) à une phase à laquelle le commutateur (18) doit être commandé pour être débloqué et à une phase à laquelle le commutateur (18) doit être commandé pour être bloqué, les phases étant incluses dans la période prédéterminée ; et
un moyen d'écrasement destiné à écrire respectivement les données ON et les données OFF par-dessus les troisièmes données qui ont été écrites aux adresses sources de transfert calculées par le moyen de calcul.

9. Circuit de commutation selon la revendication 8, comprenant en outre :
un deuxième moyen d'écrasement destiné à écrire les troisièmes données par-dessus un contenu de l'adresse source de transfert à laquelle les données ON ou les données OFF ont été écrites ; et
un moyen de mise à jour destiné à mettre à jour l'adresse source de transfert à partir de laquelle les données de transfert sont transférées par DMA au commutateur (18) à la phase à laquelle le commutateur (18) doit être commandé pour être débloqué ou à une phase à laquelle le commutateur (18) doit être commandé pour être bloqué,
dans lequel le moyen d'écrasement est conçu pour écrire les données ON ou les données OFF par-dessus les troisièmes données qui ont été écrites à l'adresse source de transfert mise à jour par le moyen de mise à jour.

10. Circuit de commutation selon la revendication 9, comprenant en outre :
un moyen de stockage destiné à stocker l'adresse source de transfert à laquelle les données ON ou les données OFF ont été écrites ;
un moyen de comparaison destiné à comparer l'adresse source de transfert stockée par le moyen de stockage et l'adresse source de transfert mise à jour par le moyen de mise à jour ; et
un moyen de désactivation destiné à désactiver l'écrasement des troisièmes données et l'écrasement des données ON ou des données OFF s'il ressort d'un résultat de la comparaison par le moyen de comparaison que les adresses sources de transfert concordent entre elles.

11. Circuit de commutation selon l'une quelconque des revendications 8 à 10, dans lequel le moyen d'écrasement est conçu pour écrire les données ON (de données OFF) par-dessus les troisièmes données qui ont été écrites à l'adresse source de transfert qui a été calculée par le moyen de calcul ou mise à jour par le moyen de mise à jour, et à une adresse à distance de l'adresse source de transfert calculée ou mise à jour.

12. Circuit de commutation selon l'une quelconque des revendications 8 à 11, dans lequel le circuit de commutation est pourvu d'une pluralité des commutateurs (18),
les multiples commutateurs (18) sont conçus pour être commandés individuellement afin d'être débloqués et bloqués par l'une des données de transfert provenant du contrôleur de DMA (15), et
une plage de phases auxquelles aucun des commutateurs (18) n'est commandé pour être débloqué/bloqué est définie à l'avance dans la période prédéterminée, le circuit de commutation comprend en outre :
un second moyen de stockage destiné à stocker une plage d'adresses sources de transfert à partir desquelles les données de transfert sont transférées par DMA au commutateur (18) à l'intérieur de la plage définie de phases ; et
un troisième moyen d'écrasement destiné à écrire une autre troisième donnée par-dessus les troisièmes données qui ont été écrites à une adresse appropriée à l'intérieur de la plage d'adresses sources de transfert qui a été stockée par la seconde section de stockage.

13. Circuit de commutation selon l'une quelconque des revendications 8 à 11, comprenant en outre :
un second moyen de calcul destiné à calculer des adresses sources de transfert à partir desquelles les données de transfert sont transférées par DMA au commutateur (18) à la phase à laquelle le commutateur (18) doit être commandé afin d'être débloqué et à la phase à laquelle le commutateur (18) doit être commandé afin d'être bloqué, à partir d'adresses à numéros impairs ou à numéros pairs dans la région prédéterminée ; et
un quatrième moyen d'écrasement destiné à écrire une autre troisième donnée par-dessus les troisièmes données qui ont été écrites à une adresse appropriée des adresses à numéros pairs ou à numéros impairs dans la région prédéterminée.

14. Circuit de commutation selon l'une quelconque des revendications 8 à 13, dans lequel une limite entre des données de transfert qui doivent être transférées par DMA de façon séquentielle dans la région prédéterminée est définie à l'avance, et
le circuit de commutation comprend en outre un cinquième moyen d'écrasement destiné, pendant qu'une donnée de transfert se trouvant d'un côté avant ou d'un côté arrière de la limite est transférée par DMA, à écrire une autre donnée de transfert par-dessus une donnée de transfert appropriée du côté arrière ou du côté avant.
